# EUROPEAN PATENT APPLICATION

(11) **EP 4 679 990 A1**
(43) Date of publication of application: **14.01.2026**
(21) Application number: 24767311.4
(22) Date of filing: 21.02.2024
(51) Int. Cl.: H10K 59/131, H10K 59/80, H10K 59/121, H10K 59/123, H01L 27/12, G09G 3/32, H01L 27/15

(54) **DISPLAY DEVICE**

(30) Priority: 03.03.2023 KR 20230028142; 16.05.2023 KR 20230063403
(71) Applicant: Samsung Display Co., Ltd., Yongin-si, Gyeonggi-do 17113 (KR)
(72) Inventor: KIM, Su Jin, Yongin-Si Gyeonggi-do 17113 (KR); KANG, Chul Kyu, Yongin-Si Gyeonggi-do 17113 (KR); KIM, Dong Hyun, Yongin-Si Gyeonggi-do 17113 (KR); MOK, Seon Kyoon, Yongin-Si Gyeonggi-do 17113 (KR); SHIM, Jong Sik, Yongin-Si Gyeonggi-do 17113 (KR); JEON, Dong Hwan, Yongin-Si Gyeonggi-do 17113 (KR)
(74) Representative: Marks & Clerk LLP
(86) International application number: PCT/KR2024/002281
(87) International publication number: WO 2024/186022

(57) **Abstract**

Disclosed in one embodiment of the present invention is a display device comprising: a first transistor including a first gate electrode and a first semiconductor layer, a second transistor including a second gate electrode and a second semiconductor layer, a node electrode for connecting the first transistor and the second transistor; a first conductive layer, which is arranged on the node electrode and overlaps the node electrode; and a pixel electrode, which is arranged on the first conductive layer and is arranged in the vicinity of the node electrode.

## Description

### Technical Field

One or more embodiments relate to a pixel and a display apparatus including the same.

### Background Art

Recently, the usage of display apparatuses has diversified. Moreover, display apparatuses have become thinner and lighter, and thus, the usage thereof has expanded.

As display apparatuses are being used for various purposes, there are various methods of designing the shapes of display apparatuses, and functions which may be connected to or associated with display apparatuses have increased.

### Disclosure of Invention

### Technical Problem

One or more embodiments include a display apparatus having improved display quality. However, this aspect is an example, and the scope of the disclosure is not limited thereto.

### Solution to Problem

According to one or more embodiments, a display apparatus includes a first transistor including a first gate electrode, and a first semiconductor layer, a second transistor including a second gate electrode, and a second semiconductor layer, a node electrode connecting the first transistor to the second transistor, a first conductive layer disposed above the node electrode and overlapping the node electrode in plan view, and a pixel electrode disposed above the first conductive layer and disposed around the node electrode.

The node electrode may connect the first gate electrode of the first transistor to an end of the second semiconductor layer of the second transistor.

The first conductive layer may be connected to an end of the first semiconductor layer of the first transistor.

The node electrode may be disposed on a layer between the first gate electrode of the first transistor and the first conductive layer.

The display apparatus may further include a second conductive layer connected to an end of the first semiconductor layer of the first transistor, wherein the node electrode may be disposed on a layer between the first conductive layer and the second conductive layer, and the first conductive layer may overlap the second conductive layer in plan view.

The display apparatus may further include a first electrode disposed on a substrate, wherein the first electrode may be disposed on a layer between the substrate and the second conductive layer, the second conductive layer may overlap the first electrode in plan view, and the first gate electrode of the first transistor may overlap the second conductive layer in plan view.

The second conductive layer may overlap a channel area of the first semiconductor layer of the first transistor in plan view.

The display apparatus may further include a first conductive line connected to the first electrode and extending in a first direction, and a second conductive line connected to another end of the second semiconductor layer of the second transistor and extending in a second direction.

The display apparatus may further include a first vertical conductive line connected to the first conductive line and extending in the second direction that is perpendicular to the first direction, and a second vertical conductive line connected to the second conductive line and extending in the second direction.

The first vertical conductive line, the second vertical conductive line, and the second conductive layer may be disposed on a same layer.

The display apparatus may further include a second electrode, wherein the second electrode and the first electrode are disposed on a same layer, and the second electrode may be connected to the node electrode.

According to one or more embodiments, a display apparatus includes, in each of a first circuit area in which a first pixel circuit is disposed and a second circuit area in which a second pixel circuit is disposed, a node electrode connecting a driving transistor to a switching transistor, and a first conductive layer disposed above the node electrode and overlapping the node electrode in plan view, wherein a pixel electrode connected to a driving transistor of the second circuit area may be disposed around the node electrode disposed in the first circuit area.

The node electrode may connect a gate electrode of the driving transistor to an end of a semiconductor layer of the switching transistor.

The first conductive layer may be connected to an end of a semiconductor layer of the driving transistor.

The node electrode may be disposed on a layer between the gate electrode of the driving transistor and the first conductive layer.

The display apparatus may further include in each of the first circuit area and the second circuit area, a second conductive layer connected to the end of the semiconductor layer of the driving transistor, wherein the node electrode may be disposed on a layer between the first conductive layer and the second conductive layer, the first conductive layer may overlap the second conductive layer in plan view, and the gate electrode of the driving transistor may overlap the second conductive layer in plan view.

The display apparatus may further include a first electrode and a second electrode disposed to be spaced apart from each other in the first circuit area, wherein the first electrode and the second electrode may be disposed on a layer between a substrate and the second conductive layer disposed in the first circuit area, the second conductive layer disposed in the first circuit area may overlap the first electrode and the second electrode in plan view, the first electrode may be connected to a driving voltage line through which a driving voltage is supplied, and the second electrode may be connected to the node electrode disposed in the first circuit area.

The display apparatus may further include a third electrode disposed in the second circuit area, wherein the third electrode and the first electrode may be disposed on a same layer, the second conductive layer disposed in the second circuit area may overlap the third electrode in plan view, and the third electrode may be connected to the driving voltage line.

An overlapping area of the first electrode and the second conductive layer in the first circuit area may be different from an overlapping area of the third electrode and the second conductive layer in the second circuit area.

The display apparatus may further include a vertical conductive line connected to the driving voltage line and extending in a direction that is perpendicular to an extension direction of the driving voltage line.

### Advantageous Effects of Invention

According to one or more of the above embodiments of the disclosure, a display apparatus having improved display quality may be provided. However, the scope of the disclosure is not limited to the effect as described above.

### Brief Description of Drawings

FIGS. 1a and 1b are schematic views of a display apparatus according to an embodiment.
FIG. 2 is a schematic view of a display apparatus according to an embodiment.
FIG. 3 is a schematic diagram of an equivalent circuit of a pixel according to an embodiment.
FIGS. 4 to 8 are schematic diagrams of equivalent circuits of a pixel according to an embodiment.
FIGS. 9 and 10 are schematic views of a capacitor according to an embodiment.
FIG. 11 is a schematic plan view of locations of transistors and capacitors of pixels according to an embodiment.
FIGS. 12 to 22 are schematic plan views showing elements of a pixel for each layer.
FIG. 23 is a schematic cross-sectional view of the pixel, taken along line I-I' of FIGS. 12 and 21.
FIG. 24 is a schematic cross-sectional view of the pixel, taken along line II-II' of FIGS. 12 and 21.
FIG. 25 is a schematic view of a capacitor for each pixel, according to an embodiment.
FIG. 26a is a schematic cross-sectional view of capacitors of a first pixel, taken along line Illa-Illa' of FIG. 25.
FIG. 26b is a schematic cross-sectional view of capacitors of a second pixel, taken along line IVa-IVa' of FIG. 25.
FIG. 26c is a schematic cross-sectional view of capacitors of a third pixel, taken along line Va-Va' of FIG. 25.
FIG. 27 is a schematic view of a capacitor for each pixel, according to an embodiment.
FIG. 28a is a schematic cross-sectional view of capacitors of a first pixel, taken along a line IIIb-IIIb' of FIG. 27.
FIG. 28b is a cross-sectional view of capacitors of a second pixel, taken along line IVb-IVb' of FIG. 27.
FIG. 28c is a schematic cross-sectional view of capacitors of a third pixel, taken along line Vb-Vb' of FIG. 27.
FIG. 29 is a schematic view of a capacitor for each pixel, according to an embodiment.
FIG. 30a is a schematic cross-sectional view of capacitors of a first pixel, taken along line IIIc-IIIc' of FIG. 29.
FIG. 30b is a schematic cross-sectional view of capacitors of a second pixel, taken along line IVc-IVc' of FIG. 29.
FIG. 30c is a schematic cross-sectional view of capacitors of a third pixel, taken along line Vc-Vc' of FIG. 29.
FIGS. 31 to 33 are schematic plan views of vertical conductive lines according to an embodiment.
FIGS. 34a to 35b are schematic cross-sectional views showing a structure of a display element according to an embodiment.
FIG. 36 is a schematic cross-sectional view showing a structure of a pixel of a display apparatus according to an embodiment.

### Best Mode for Carrying out the Invention

According to one or more embodiments, a display apparatus includes a first transistor including a first gate electrode, and a first semiconductor layer, a second transistor including a second gate electrode, and a second semiconductor layer, a node electrode connecting the first transistor to the second transistor, a first conductive layer disposed above the node electrode and overlapping the node electrode in plan view, and a pixel electrode disposed above the first conductive layer and disposed around the node electrode.

### Mode for the Invention

It is to be understood that the present disclosure is susceptible to various changes and may have numerous embodiments. Specific embodiments are illustrated in the drawings and described in the detailed description. The effects and features of the present disclosure, as well as a method of achieving them, will become apparent with reference to the embodiments described in detail below with the following drawings. However, the present disclosure is not limited to the embodiments disclosed herein and may be implemented in various forms.

As used herein, the term "and/or" includes any and all combinations of one or more of the associated listed items. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

It will be understood that although the terms "first," "second," etc. may be used herein to describe various elements, these elements should not be limited by these terms. These terms are only used to distinguish one element from another.

As used herein, the singular expressions "a," "an," and "the" are intended to include the plural forms as well, unless the context clearly indicates otherwise.

The terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof. It will be understood that when a layer, region, or element is referred to as being formed "on" another layer, area, or element, it can be directly or indirectly formed on the other layer, region, or element. For example, intervening layers, regions, or elements may be present.

It will be understood that the terms "connected to" or "coupled to" may include a physical and/or electrical connection or coupling. It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

A case where X and Y are electrically connected to each other may include, for example, a case where at least one device (e.g., a switch, a transistor, a capacitance device, an inductor, a resistance device, a diode, etc.) for electrical connection between X and Y is connected between X and Y.

In an embodiment described hereinafter, the terms "on" and "off" used in relation to a device state refer to an activated state of the device and a non-activated state of the device, respectively. The terms "on" and "off" used in relation to a signal received by a device may refer to a signal configured to activate the device and a signal configured to non-activate the device, respectively. The device may be activated by a high-level voltage or a low-level voltage. For example, a P-channel transistor (a P-type transistor) may be activated by a low-level voltage, and an N-channel transistor (an N-type transistor) may be activated by a high-level voltage. Thus, it shall be understood that the "on" voltages with respect to the P-type transistor and the N-type transistor may have voltage levels which are the opposite to each other (low versus high).

In an embodiment described hereinafter, an x direction, a y direction, and a z direction may not be limited to directions in three axes on a rectangular coordinate system and may be interpreted in a broader sense. For example, the x direction, the y direction, and the z direction may be perpendicular to one another or may refer to different directions that are not perpendicular to one another.

The term "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as "not overlapping" or to "not overlap" another element, this may include that the elements are spaced apart from each other, offset from each other, or set aside from each other or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

A display apparatus according to some embodiments may be an apparatus displaying a video or a static image. The display apparatus 1 may be used as a display screen of various devices, such as a television, a notebook computer, a monitor, a broadcasting panel, and an Internet of things (IOT) device, as well as portable electronic devices, such as a mobile phone, a smart phone, a tablet personal computer (PC), a mobile communication terminal, an electronic notebook, an electronic book, a portable multimedia player (PMP), a navigation device, and a ultra mobile PC (UMPC). Also, the display apparatus 1 according to an embodiment may be used in wearable devices, such as a smart watch, a watch phone, a glasses-type display, and a head-mounted display (HMD). Also, the display apparatus 1 according to an embodiment may be used as a center information display (CID) on a gauge of a vehicle or a center fascia or a dashboard of the vehicle, a room mirror display substituting a side-view mirror of a vehicle, or a display disposed on a rear surface of a front seat, as an entertainment device for a backseat of a vehicle. Also, the display apparatus may be a flexible device.

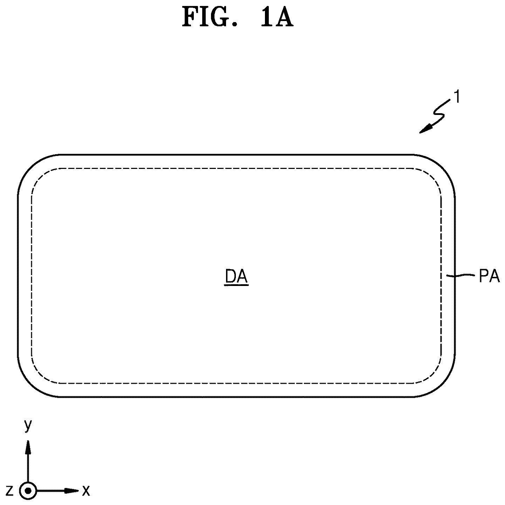

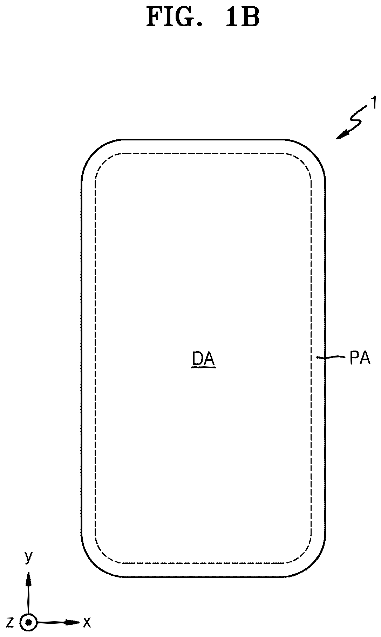

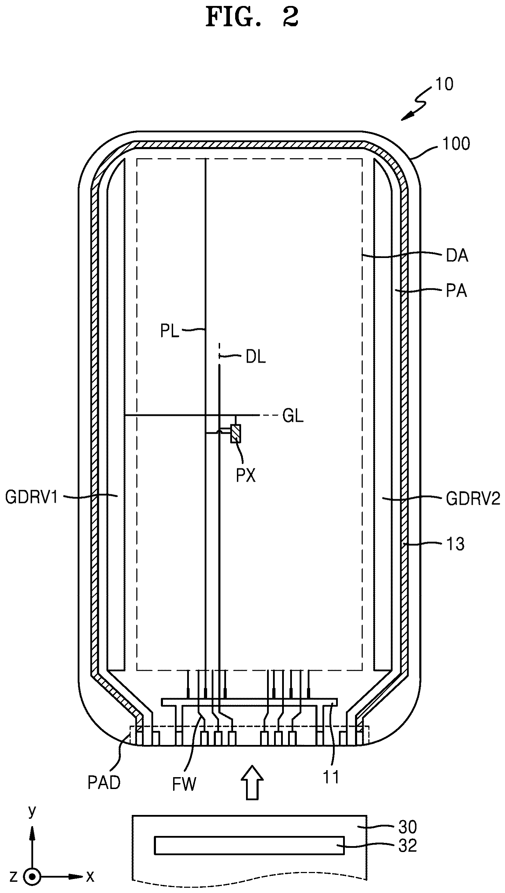

FIGS. 1a and 1b are schematic views of the display apparatus according to an embodiment. FIG. 2 is a schematic view of the display apparatus according to an embodiment.

Referring to FIGS. 1a and 1b, the display apparatus 1 may include a display area DA for displaying an image and a peripheral area PA outside the display area DA. The display area DA may be entirely surrounded by the peripheral area PA.

In a plan view, the display area DA may have a rectangular shape. According to another embodiment, the display area DA may have a polygonal shape, such as a triangular shape, a pentagonal shape, a hexagonal shape, etc., a circular shape, an oval shape, an amorphous shape, etc. The display area DA may have a rounded corner. According to an embodiment, the display apparatus 1 may have the display area DA, a length of which in an x direction is greater than a length of which in a y direction, as illustrated in FIG. 1a. According to another embodiment, the display apparatus 1 may have the display area DA, a length of which in a y direction is greater than a length of which in an x direction, as illustrated in FIG. 1b.

The display apparatus 1 may include a display panel 10, and a cover window (not shown) protecting the display panel 10 may be arranged (disposed) above the display panel 10.

Various elements included in the display panel 10 may be arranged on a substrate 100. The substrate 100 may include the display area DA and a peripheral area PA surrounding the display area DA.

Pixels PX may be arranged in the display area DA. Gate lines GL, data lines DL, and pixels PX connected to the gate lines GL and the data lines DL may be arranged in the display area DA. The pixels PX may be arranged in various arrangement forms, for example, a stripe form, a PenTile^{®} form, a diamond form, a mosaic form, etc., to realize an image. Each pixel PX may include an organic light-emitting diode as a display element (a light-emitting device), and the organic light-emitting diode may be connected to a pixel circuit. The pixel circuit may include transistors and at least one capacitor. The pixel PX may emit, for example, red, green, blue, or white light through the organic light-emitting diode. Each pixel PX may be connected to a gate line corresponding to the pixel PX from among the gate lines GL and a data line corresponding to the pixel PX from among the data lines DL.

Each of the gate lines GL may extend in the x direction (a row direction) and may be connected to the pixels PX arranged in the same row. Each of the gate lines GL may be configured to transmit a gate signal to the pixels PX arranged in the same row. Each of the data lines DL may extend in the y direction (a column direction) and may be connected to the pixels PX arranged in the same column. Each of the data lines DL may be synchronized to the gate signal and may be configured to transmit a data signal to each of the pixels PX in the same column. Each pixel PX may be connected to a driving voltage line PL and may be supplied with a driving voltage ELVDD. Each of the driving voltage lines PL may extend in the y direction (the column direction) and may be connected to the pixels PX arranged in the same column.

FIG. 2 illustrates an example in which the pixel PX is connected to one gate line GL. However, an embodiment is not limited thereto. The pixel PX may be connected to one or more gate lines GL.

Each of the pixel circuits configured to drive the pixels PX may be connected (e.g., electrically connected) to outer circuits arranged in the peripheral area PA. A first gate driving circuit GDRV1, a second gate driving circuit GDRV2, a terminal portion PAD, a driving voltage supply line 11, a common voltage supply line 13, etc. may be arranged in the peripheral area PA.

According to an embodiment, the peripheral area PA may be a type of non-display area in which the pixels PX are not arranged. According to another embodiment, a portion of the peripheral area PA may be realized as the display area DA. For example, the pixels PX may be arranged in at least one corner of the peripheral area PA to overlap the outer circuit. Thus, a dead space (e.g., an unutilized space) may be reduced, and the display area DA may be expanded.

The first gate driving circuit GDRV1 may be connected to the gate lines GL and may be configured to apply, through the gate lines GL, the gate signal to each of the pixel circuits configured to drive the pixels PX. The second gate driving circuit GDRV2 may be arranged on the opposite side to the first gate driving circuit GDRV1 with respect to the display area DA and may be approximately in parallel with the first gate driving circuit GDRV1. According to an embodiment, the pixel circuits of the pixels PX of the display area DA may be connected (e.g., electrically connected) to the first gate driving circuit GDRV1 and the second gate driving circuit GDRV2. According to another embodiment, some of the pixel circuits of the pixels PX of the display area DA may be connected (e.g., electrically connected) to the first gate driving circuit GDRV1 and the others may be connected (e.g., electrically connected) to the second gate driving circuit GDRV2. The second gate driving circuit GDRV2 may be omitted.

The terminal portion PAD may be arranged at a side of the substrate 100. The terminal portion PAD may not be covered by an insulating layer to be exposed and may be connected to a display circuit board 30. A display driver 32 may be arranged on the display circuit board 30.

The display driver 32 may include a data driving circuit. The data driving circuit may be connected to the data lines DL and may be configured to generate the data signal. The generated data signal may be transmitted to the pixel circuits of the pixels PX through a fanout line FW and the data line DL connected to the fanout line FW.

The display driver 32 may include a power supply circuit, and the power supply circuit may be configured to supply the driving voltage ELVDD to the driving voltage supply line 11 and a common voltage ELVSS to the common voltage supply line 13. The driving voltage ELVDD may be applied to the pixel circuits of the pixels PX through the driving voltage line PL connected to the driving voltage supply line 11, and the common voltage ELVSS may be applied to an opposite electrode of a display element through the common voltage supply line 13.

The display driver 32 may include a controller, and the controller may be configured to generate a control signal transmitted to the first gate driving circuit GDRV1, the second gate driving circuit GDRV2, the data driving circuit, and the power supply circuit.

The driving voltage supply line 11 may be connected the terminal portion PAD and may extend in the x direction at a lower portion of the display area DA. The common voltage supply line 13 may be connected to the terminal portion PAD and may have a loop shape having an open side to partially surround the display area DA.

The first gate driving circuit GDRV1 and the second gate driving circuit GDRV2 may be partially or entirely formed (e.g., directly) in the peripheral area PA of the substrate 100, during a process of forming the pixel circuit in the display area DA of the substrate 100. The display driver 32 may be formed as an integrated circuit chip and may be arranged on the display circuit board 30 connected (e.g., electrically connected) to the terminal portion PAD arranged at a side of the substrate 100. The display circuit board 30 may include a flexible printed circuit board (FPCB). According to another embodiment, the display driver 32 may be directly arranged on the substrate 100 as a chip on glass (COG) or a chip on plastic (COP).

According to an embodiment, the transistors included in the pixel circuits of the display area DA and transistors included in the outer circuit of the peripheral area PA, for example, the first gate driving circuit GDRV1 and the second gate driving circuit GDRV2, may be N-type oxide thin-film transistors. The transistors included in the outer circuit of the peripheral area PA may be simultaneously formed with the transistors included in the pixel circuits of the display area DA during the same process. According to another embodiment, the transistors included in the pixel circuits of the display area DA may be N-type oxide thin-film transistors, and the transistors included in the outer circuit of the peripheral area PA may be P-type silicon thin-film transistors.

The oxide thin-film transistor may include a semiconductor layer including an oxide. The oxide semiconductor may include a Zn oxide-based material, such as a Zn oxide, an In-Zn oxide, a Ga-In-Zn oxide, etc. According to some embodiments, the oxide semiconductor may include an In-Ga-Zn-O (IGZO) semiconductor in which metals including In and Ga are contained in ZnO. According to an embodiment, the oxide thin-film transistor may include a low temperature polycrystalline oxide (LTPO) thin-film transistor. The silicon thin-film transistor may include a low temperature poly-silicon (LTPS) thin-film transistor in which a semiconductor layer includes amorphous silicon, poly silicon, etc.

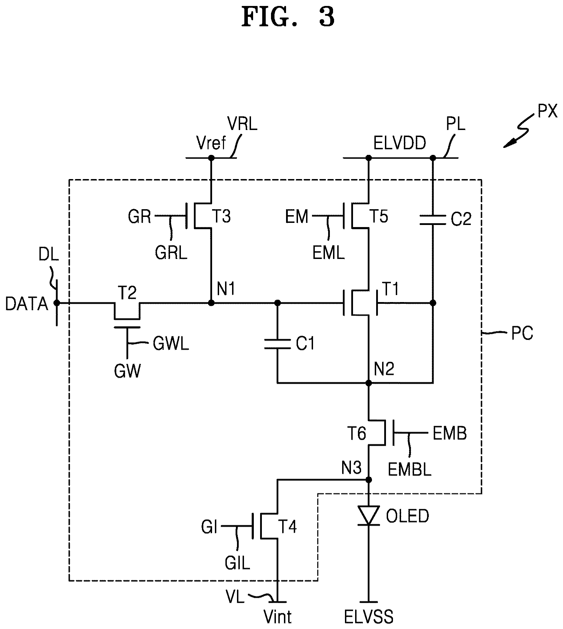

FIG. 3 is a schematic diagram of an equivalent circuit of a pixel PX according to an embodiment.

Referring to FIG. 3, the pixel PX may include a pixel circuit PC and an organic light-emitting diode OLED as a display element connected to the pixel circuit PC.

The pixel PX may be connected to a first gate line GWL configured to transmit a first gate signal GW, a second gate line GIL configured to transmit a second gate signal GI, a third gate line GRL configured to transmit a third gate signal GR, a fourth gate line EML configured to transmit a fourth gate signal EM, a fifth gate line EMBL configured to transmit a fifth gate signal EMB, and a data line DL configured to transmit a data signal. Emission of the pixel PX may be controlled by the fourth gate signal EM and the fifth gate signal EMB, and thus, the fourth gate signal EM and the fifth gate signal EMB may also be referred to as emission control signals, and the fourth gate line EML and the fifth gate line EMBL may also be referred to as emission control lines. Also, the pixel PX may be connected to a driving voltage line PL configured to transmit a driving voltage ELVDD, a reference voltage line VRL configured to transmit a reference voltage Vref, and an initialization voltage line VL configured to transmit an initialization voltage Vint.

According to an embodiment, transistors included in the pixel circuit PC may include N-type oxide thin-film transistors. The oxide thin-film transistor may include an LTPO thin-film transistor including a semiconductor layer including an oxide. However, the LTPO thin-film transistor is only an example, and the N-type transistors are not limited thereto. For example, the semiconductor layer included in the N-type transistor may include an inorganic semiconductor (e.g., amorphous silicon, polysilicon, etc.) or an organic semiconductor.

The pixel circuit PC may include first to sixth transistors T1 to T6 and first and second capacitors C1 and C2. The first transistor T1 may be a driving transistor configured to output a driving current corresponding to a data signal, and the second to sixth transistors T2 to T6 may be switching transistors configured to transmit signals. A first terminal (a first electrode) and a second terminal (a second electrode) of each of the first to sixth transistors T1 to T6 may be a source or a drain according to voltages of the first terminal and the second terminal. For example, according to the voltages of the first terminal and the second terminal, the first terminal may be a drain, and the second terminal may be a source, or the first terminal may be a source, and the second terminal may be a drain. Hereinafter, a node to which a first gate of the first transistor T1 is connected may be defined as a first node N1, and a node to which the second terminal of the first transistor T1 is connected may be defined as a second node N2.

The first transistor T1 may be connected to the driving voltage line PL and the organic light-emitting diode OLED. The first transistor T1 may be connected between the fifth transistor T5 and the sixth transistor T6. The first transistor T1 may include a gate, the first terminal, and the second terminal that is connected to the second node N2. The first transistor T1 may include the first gate connected to the first node N1. The first transistor T1 may further include a second gate connected to the second terminal of the first transistor T1. The first gate and the second gate may be arranged on different layers from each other to face each other. For example, the first gate and the second gate of the first transistor T1 may be arranged to face each other with the semiconductor layer therebetween. Hereinafter, a gate (or a gate electrode) of the first transistor T1 may denote the first gate involved in the turning on and turning off of the first transistor T1.

The first gate of the first transistor T1 may be connected to the second terminal of the second transistor T2, the first terminal of the third transistor T3, and the first capacitor C1. The second gate of the first transistor T1 may be connected to the first terminal of the sixth transistor T6, the first capacitor C1, and the second capacitor C2. The first terminal of the first transistor T1 may be connected to the driving voltage line PL through the fifth transistor T5, and the second terminal of the first transistor T1 may be connected to a pixel electrode of the organic light-emitting diode OLED through the sixth transistor T6. The first terminal of the first transistor T1 may be connected to the second terminal of the fifth transistor T5. The second terminal of the first transistor T1 may be connected to the first terminal of the sixth transistor T6, the first capacitor C1, and the second capacitor C2. The first transistor T1 may be configured to receive a data signal DATA according to a switching operation of the second transistor T2 and may be configured to control a current amount of a driving current flowing to the organic light-emitting diode OLED.

The second transistor T2 (a write transistor) may be connected to the data line DL and the first gate of the first transistor T1. The second transistor T2 may include a gate connected to the first gate line GWL, the first terminal connected to the data line DL, and the second terminal connected to the first node N1. The second terminal of the second transistor T2 may be connected to the first gate of the first transistor T1, the first terminal of the third transistor T3, and the first capacitor C1. The second transistor T2 may be turned on by the first gate signal GW transmitted through the first gate line GWL and may be configured to connect (e.g., electrically connect) the data line DL with the first node N1 and transmit the data signal DATA transmitted through the data line DL to the first node N1.

The third transistor T3 (a first initialization transistor) may be connected to the first gate of the first transistor T1 and the reference voltage line VRL. The third transistor T3 may include a gate connected to the third gate line GRL, the first terminal connected to the first node N1, and the second terminal connected to the reference voltage line VRL. The first terminal of the third transistor T3 may be connected to the first gate of the first transistor T1, the second terminal of the second transistor T2, and the first capacitor C1. The third transistor T3 may be turned on by the third gate signal GR transmitted through the third gate line GRL and may be configured to transmit the reference voltage Vref transmitted through the reference voltage line VRL to the first node N1.

The fourth transistor T4 (a second initialization transistor) may be connected to the sixth transistor T6 and the initialization voltage line VL. The fourth transistor T4 may be connected between the organic light-emitting diode OLED and the initialization voltage line VL. The fourth transistor T4 may include a gate connected to the second gate line GIL, the first terminal connected to a third node N3, and the second terminal connected to the initialization voltage line VL. The first terminal of the fourth transistor T4 may be connected to the second terminal of the sixth transistor T6 and the pixel electrode of the organic light-emitting diode OLED. The fourth transistor T4 may be turned on by the second gate signal GI transmitted through the second gate line GIL and may be configured to transmit the initialization voltage Vint transmitted through the initialization voltage line VL to the third node N3.

The fifth transistor T5 (a first emission control transistor) may be connected to the driving voltage line PL and the first transistor T1. The fifth transistor T5 may include a gate connected to the fourth gate line EML, the first terminal connected to the driving voltage line PL, and the second terminal connected to the first terminal of the first transistor T1. The fifth transistor T5 may be turned on or turned off according to the fourth gate signal EM transmitted through the fourth gate line EML.

The sixth transistor T6 (a second emission control transistor) may be connected to the first transistor T1 and the organic light-emitting diode OLED. The sixth transistor T6 may be connected between the second node N2 and the third node N3. The sixth transistor T6 may include a gate connected to the fifth gate line EMBL, the first terminal connected to the second node N2, and the second terminal connected to the third node N3. The first terminal of the sixth transistor T6 may be connected to the second terminal of the first transistor T1, the first capacitor C1, and the second capacitor C2. The second terminal of the sixth transistor T6 may be connected to the first terminal of the fourth transistor T4 and the pixel electrode of the organic light-emitting diode OLED. The sixth transistor T6 may be turned on or turned off according to the fifth gate signal EMB transmitted through the fifth gate line EMBL.

The first capacitor C1 may be connected between the first gate of the first transistor T1 and the second terminal of the first transistor T1. A first electrode of the first capacitor C1 may be connected to the first node N1, and a second electrode of the first capacitor C1 may be connected to the second node N2. The first electrode of the first capacitor C1 may be connected to the first gate of the first transistor T1, the second terminal of the second transistor T2, and the first terminal of the third transistor T3. The second electrode of the first capacitor C1 may be connected to the second terminal and the second gate of the first transistor T1, the second electrode of the second capacitor C2, and the first terminal of the sixth transistor T6. The first capacitor C1 may be a storage capacitor and may be configured to store a threshold voltage of the first transistor T1 and a voltage corresponding to the data signal DATA.

In the case that the third transistor T3 and the fifth transistor T5 are turned on together, the first transistor T1 may be turned on. In the case that a voltage of the second terminal of the first transistor T1 reaches a value of a difference Vref-Vth between the reference voltage Vref and a threshold voltage Vth of the first transistor T1, the first transistor T1 may be turned off, and a voltage corresponding to the threshold voltage Vth of the first transistor T1 may be stored in the first capacitor C1, so that the threshold voltage Vth of the first transistor T1 may be compensated for.

The second capacitor C2 may be connected between the driving voltage line PL and the second node N2. A first electrode of the second capacitor C2 may be connected to the driving voltage line PL. A second electrode of the second capacitor C2 may be connected to the second terminal and the second gate of the first transistor T1, the second electrode of the first capacitor C1, and the first terminal of the sixth transistor T6.

A capacitance of each of the first capacitor C1 and the second capacitor C2 may vary according to a color of light emitted by the pixel PX.

The organic light-emitting diode OLED may be connected to the first transistor T1 through the sixth transistor T6. The organic light-emitting diode OLED may include the pixel electrode (an anode) connected to the third node N3 and an opposite electrode (a cathode) facing the pixel electrode, and the opposite electrode may receive a common voltage EVLSS. The opposite electrode may be a common electrode, which is common to multiple pixels PX. In the case that the fifth transistor T5 and the sixth transistor T6 are turned on, the first transistor T1 may output a driving current, which may flow through the organic light-emitting diode OLED, and the organic light-emitting diode OLED may emit light by a brightness corresponding to a magnitude of the driving current.

A pixel circuit of a pixel according to an embodiment is not limited to the pixel circuit PC illustrated in FIG. 3. According to another embodiment, various pixel circuits may be implemented, the pixel circuits including the first capacitor C1 and the second capacitor C2 connected to the second terminal (the source) of the first transistor T1.

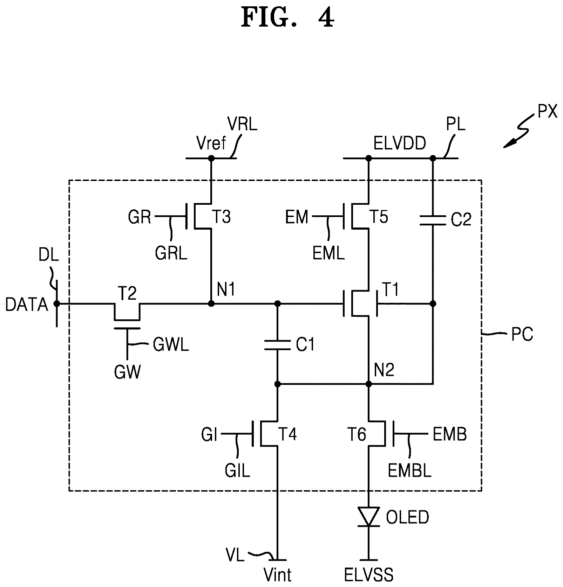

FIGS. 4 to 8 are schematic diagrams of equivalent circuits of a pixel PX according to an embodiment.

The pixel circuit PC of the pixel PX illustrated in FIG. 4 may be different from the pixel circuit PC illustrated in FIG. 3 at least in that in the pixel circuit PC of the pixel PX illustrated in FIG. 4, the fourth transistor T4 may be connected to the second node N2 and the initialization voltage line VL. The fourth transistor T4 may be turned on by the second gate signal GI transmitted through the second gate line GIL and may be configured to transmit the initialization voltage Vint transmitted through the initialization voltage line VL to the second node N2.

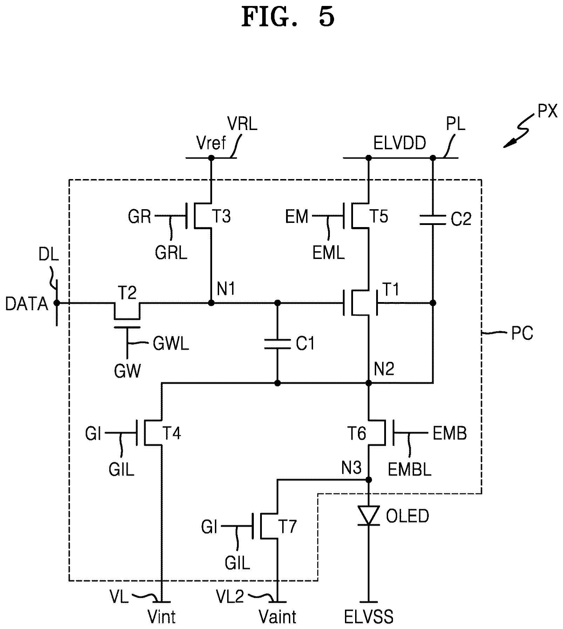

The pixel circuit PC of the pixel PX illustrated in FIG. 5 may be different from the pixel circuit PC illustrated in FIG. 4 at least in that in the pixel circuit PC of the pixel PX illustrated in FIG. 5, a seventh transistor T7 connected to the third node N3 and the second initialization voltage line VL2 may further be included. The second initialization voltage line VL2 may be separately provided from the initialization voltage line VL and may be configured to transmit a second initialization voltage Vaint to the third node N3. According to an embodiment, the second initialization voltage Vaint may have a higher voltage level than the initialization voltage Vint.

The seventh transistor T7 may be turned on by the second gate signal GI transmitted through the second gate line GIL and may be configured to transmit the second initialization voltage Vaint transmitted through the second initialization voltage line VL2 to the third node N3. The second node N2 and the third node N3 may be initialized to different voltages from each other by the fourth transistor T4 and the seventh transistor T7.

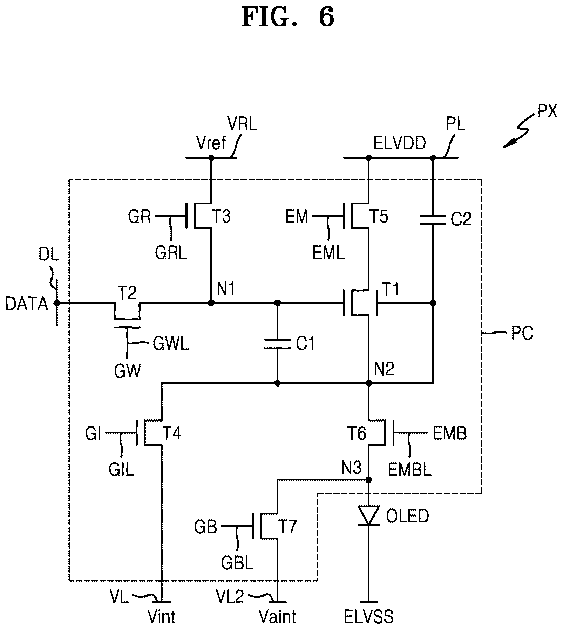

The pixel circuit PC of the pixel PX illustrated in FIG. 6 may be different from the pixel circuit PC illustrated in FIG. 5 at least in that in the pixel circuit PC of the pixel PX illustrated in FIG. 6, a gate of the seventh transistor T7 may be connected to a sixth gate line GBL and configured to receive a sixth gate signal GB. The fourth transistor T4 and the seventh transistor T7 may be connected to the different gate lines from each other and controlled by the different gate signals from each other, and thus, initialization timings of the second node N2 and the third node N3 may be separately controlled.

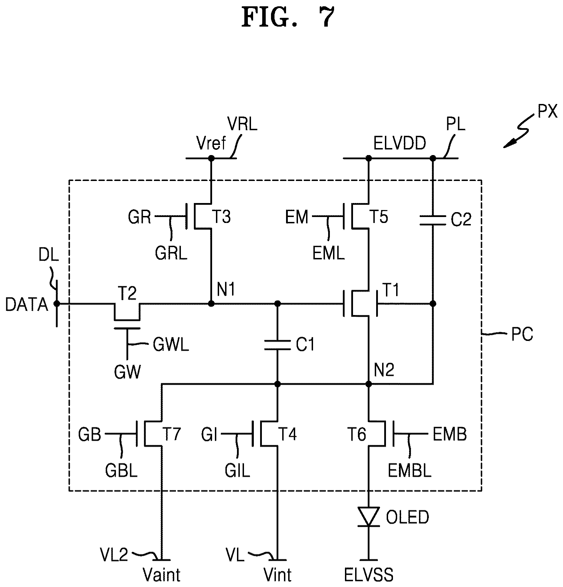

The pixel circuit PC of the pixel PX illustrated in FIG. 7 may be different from the pixel circuit PC illustrated in FIG. 6 at least in that in the pixel circuit PC of the pixel PX illustrated in FIG. 7, the seventh transistor T7 may be connected to the second node N2 and the second initialization voltage line VL2. The fourth transistor T4 and the seventh transistor T7 may be connected to the different gate lines from each other and controlled by the different gate signals from each other, and thus, initialization of the second node N2 may be precisely controlled.

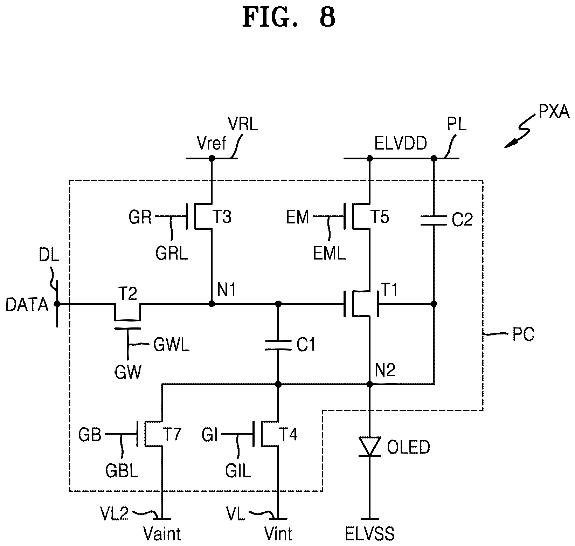

The pixel circuit PC of the pixel PX illustrated in FIG. 8 may be different from the pixel circuit PC illustrated in FIG. 7 at least in that in the pixel circuit PC of the pixel PX illustrated in FIG. 8, the sixth transistor T6 may be omitted.

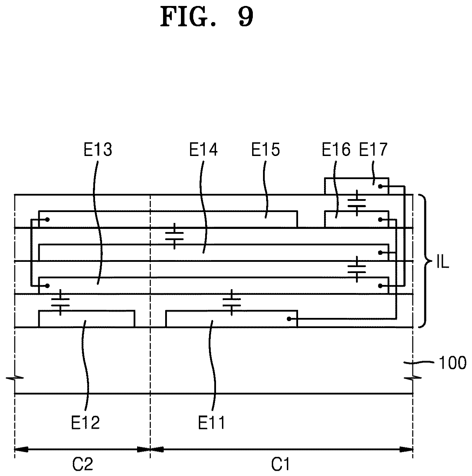

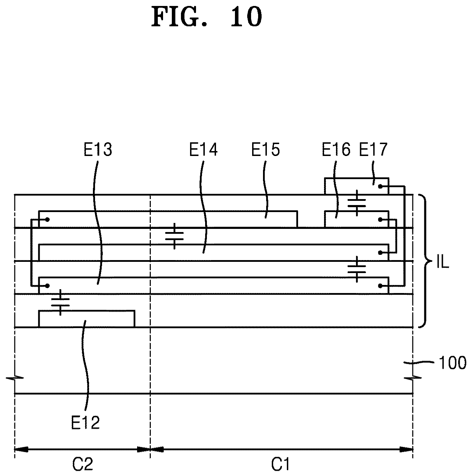

FIGS. 9 and 10 are schematic views of a capacitor according to an embodiment.

FIGS. 9 and 10 may illustrate the first capacitor C1 and the second capacitor C2 illustrated in FIGS. 3 to 8. A capacitance of the first capacitor C1 and a capacitance of the second capacitor C2 may be controlled by an overlapping area between conductive lines.

Referring to FIG. 9, a first electrode E11 and a second electrode E12 may be arranged to be spaced apart from each other on the substrate 100. A third electrode E13 overlapping the first electrode E11 and the second electrode E12 may be arranged on the first electrode E11 and the second electrode E12. A fourth electrode E14 overlapping the third electrode E13 may be arranged on the third electrode E13. A fifth electrode E15 and a sixth electrode E16 may be arranged on the fourth electrode E14 to be spaced apart from each other. The fifth electrode E15 and the sixth electrode E16 may overlap the fourth electrode E14. The fifth electrode E15 may be connected (e.g., electrically connected) to the third electrode E13. The sixth electrode E16 may be connected (e.g., electrically connected) to the fourth electrode E14 and the first electrode E11. A seventh electrode E17 overlapping the sixth electrode E16 may be arranged on the sixth electrode E16. The seventh electrode E17 may be connected (e.g., electrically connected) to the third electrode E13.

The second electrode E12 may be configured to receive the driving voltage ELVDD. The third electrode E13, the fifth electrode E15, and the seventh electrode E17 may be connected (e.g., electrically connected) to the source of the first transistor T1. The first electrode E11, the fourth electrode E14, and the sixth electrode E16 may be connected (e.g., electrically connected) to the gate (the first gate) of the first transistor T1.

At least one insulating layer IL may be arranged between the first electrode E11, the second electrode E12, and the third electrode E13. At least one insulating layer IL may be arranged between the third electrode E13 and the fourth electrode E14. At least one insulating layer IL may be arranged between the fourth electrode E14, the fifth electrode E15, and the sixth electrode E16. At least one insulating layer IL may be arranged between the sixth electrode E16 and the seventh electrode E17. The insulating layer IL may include one or more inorganic insulating layers and/or organic insulating layers.

The first capacitor C1 may have a structure in which first sub-capacitors and a second sub-capacitor are connected in parallel with each other. The first sub-capacitors may be formed by the first electrode E11, the third electrode E13 overlapping the first electrode E11, the fourth electrode E14 overlapping the third electrode E13, and the fifth electrode E15 overlapping the fourth electrode E14. Also, the second sub-capacitor may be formed by the sixth electrode E16 and the seventh electrode E17. A capacitance of the first capacitor C1 may be the sum of a capacitance formed by the first electrode E11 and the third electrode E13, a capacitance formed by the third electrode E13 and the fourth electrode E14, a capacitance formed by the fourth electrode E14 and the fifth electrode E15, and a capacitance formed by the sixth electrode E16 and the seventh electrode E17.

The second capacitor C2 may include the second electrode E12 and the third electrode E13 overlapping the second electrode E12. A capacitance of the second capacitor C2 may be the capacitance formed by the second electrode E12 and the third electrode E13.

According to another embodiment, as illustrated in FIG. 10, the first electrode E11 may be omitted. The first capacitor C1 may have a structure in which first sub-capacitors and a second sub-capacitor are connected to each other in parallel. The first sub-capacitors may be formed by the third electrode E13, the fourth electrode E14, and the fifth electrode E15. Also, the second sub-capacitor may be formed by the sixth electrode E16 and the seventh electrode E17. A capacitance of the first capacitor C1 may be the sum of a capacitance formed by the third electrode E13 and the fourth electrode E14, a capacitance formed by the fourth electrode E14 and the fifth electrode E15, and a capacitance formed by the sixth electrode E16 and the seventh electrode E17.

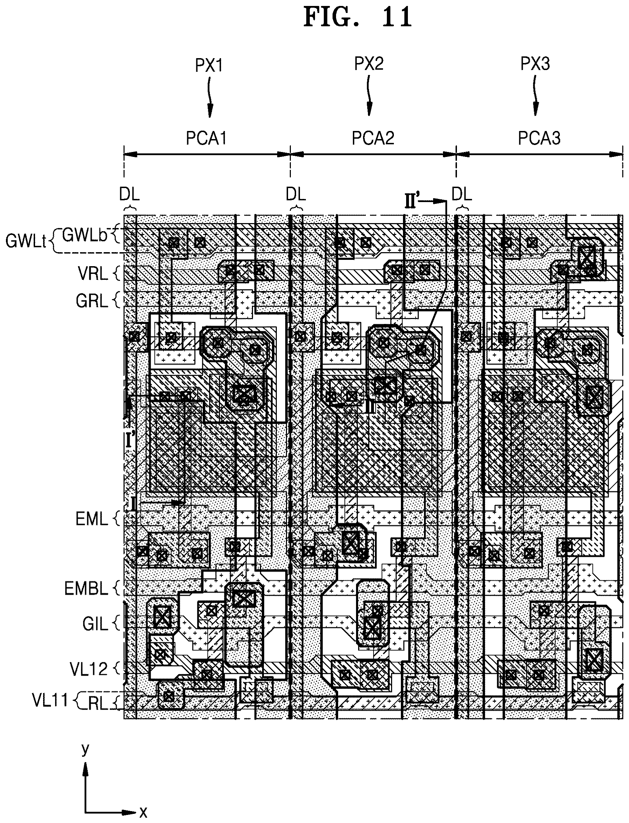

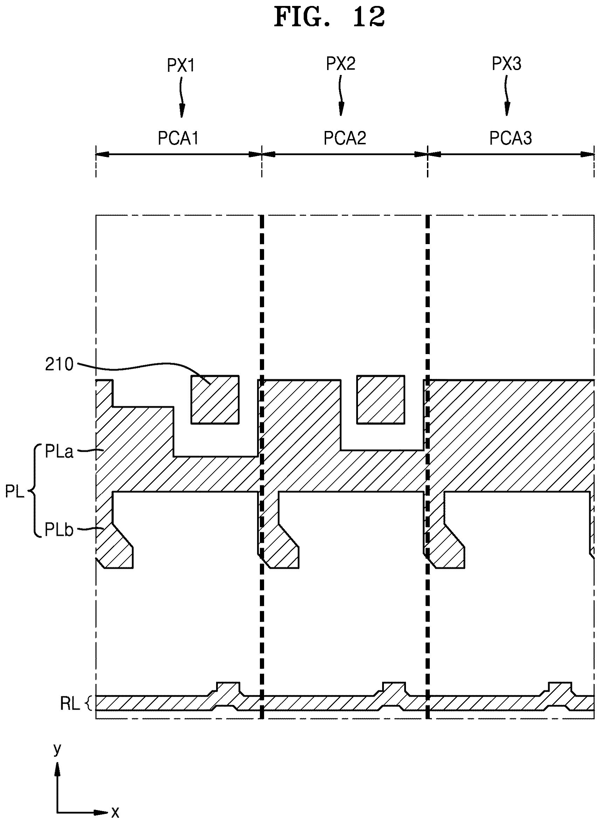

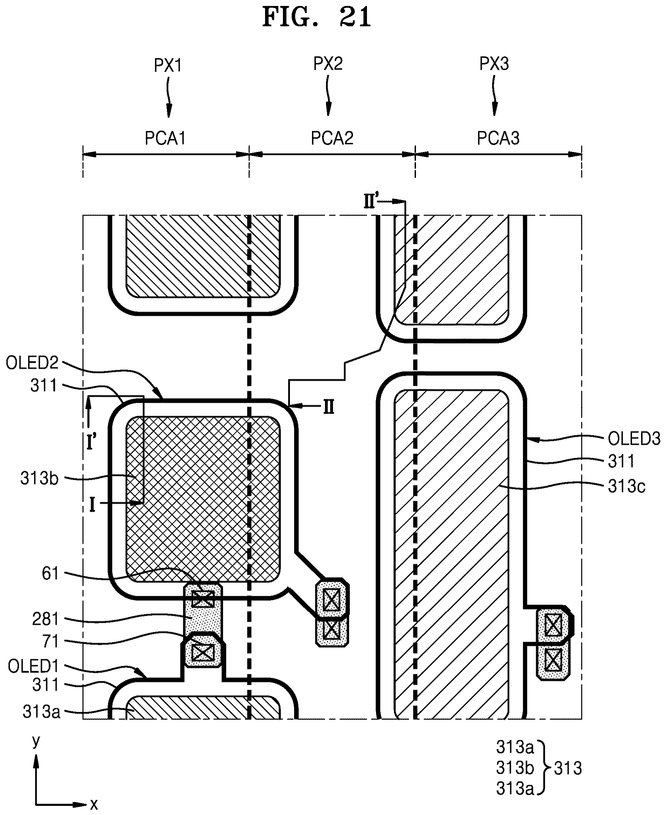

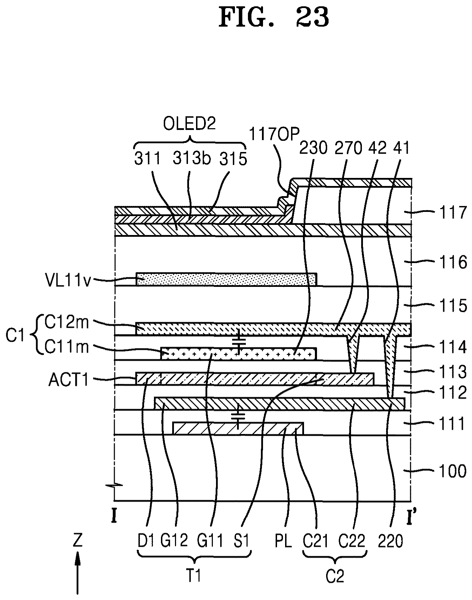

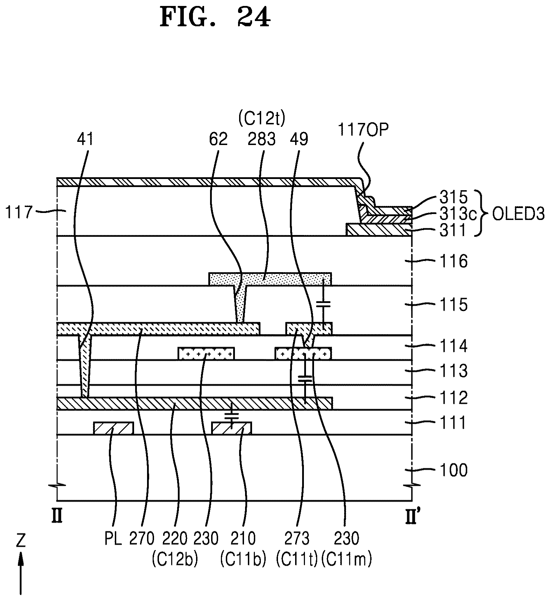

FIG. 11 is a schematic plan view of locations of transistors and capacitors of pixels according to an embodiment. FIGS. 12 to 22 are schematic plan views showing elements of a pixel for each layer. FIG. 23 is a schematic cross-sectional view of the elements of the pixel, taken along line I-I' of FIGS. 12 and 21. FIG. 24 is a schematic cross-sectional view of the elements of the pixel, taken along line II-II' of FIGS. 12 and 21.

FIG. 11 illustrates an example of the pixel circuit of the pixel illustrated in FIG. 3. However, the embodiment illustrated in FIG. 11 may be similarly applied to the pixel circuits of the pixels illustrated in FIGS. 4 to 8, and the corresponding transistors and capacitors of FIGS. 4 to 8 may have substantially the same locations as shown in FIG. 11.

The pixels PX arranged in the display area DA may include a first pixel PX1 emitting a first color, a second pixel PX2 emitting a second color, and a third pixel PX3 emitting a third color. For example, the first pixel PX1 may be a red pixel, the second pixel PX2 may be a green pixel, and the third pixel PX3 may be a blue pixel. The first pixel PX1, the second pixel PX2, and the third pixel PX3 may be repeatedly arranged in a predetermined or selected pattern in an x direction and a y direction. Each of the first pixel PX1, the second pixel PX2, and the third pixel PX3 may include a pixel circuit and an organic light-emitting diode OLED as a display element connected (e.g., electrically connected) to the pixel circuit.

The display area DA defined on the substrate 100 may include rows and columns crossing each other and may include circuit areas, in which the pixel circuit is arranged. According to an embodiment, a unit circuit area including two or more circuit areas adjacent to each other in the x direction may be defined. For example, the unit circuit area PCAu may include three circuit areas, for example, a first circuit area PCA1, a second circuit area PCA2, and a third circuit area PCA3, which are adjacent to each other in the x direction. The first circuit area PCA1 may be an area in which the pixel circuit of the first pixel PX1 is arranged. The second circuit area PCA2 may be an area in which the pixel circuit of the second pixel PX2 is arranged. The third circuit area PCA3 may be an area in which the pixel circuit of the third pixel PX3 is arranged.

Each of the pixel circuits PC arranged in the first to third circuit areas PCA1 to PCA3 may correspond to the pixel circuit PC of the pixel PX illustrated in FIG. 3. The pixel circuits PC arranged in the first to third circuit areas PCA1 to PCA3 may be connected (e.g., electrically connected) to the display elements emitting light of different colors from each other. Each of the pixel circuits PC arranged in the first to third circuit areas PCA1 to PCA3 may be configured to drive the display element connected (e.g., electrically connected) thereto. For example, the display element connected (e.g., electrically connected) to the pixel circuit arranged in the first circuit area PCA1 may emit red light. The display element connected (e.g., electrically connected) to the pixel circuit arranged in the second circuit area PCA2 may emit green light. The display element connected (e.g., electrically connected) to the pixel circuit arranged in the third circuit area PCA3 may emit blue light.

According to an embodiment, in consideration of the emission characteristics of the first to third pixels PX1 to PX3, initialization voltages Vint supplied to the first to third pixels PX1 to PX3 may be different from each other. For example, the pixel circuit PC of the first pixel PX1 may be connected to a 1-1^{st} initialization voltage line VL11, and the pixel circuits PC of the second and third pixels PX2 and PX may be connected to a 1-2^{nd} initialization voltage line VL12. The initialization voltage supplied to the 1-1^{st} initialization voltage line VL11 and the initialization voltage supplied to the 1-2^{nd} initialization voltage line VL12 may be different from each other.

The same devices may be arranged on each layer of the first to third circuit areas PCA1 to PCA3. Hereinafter, for convenience of illustration and explanation, reference numerals are assigned to the devices of the pixel circuit PC arranged in the first circuit area PCA1, and the description is given based on the first circuit area PCA1. However, the description may be likewise applied to the same elements of the second and third circuit areas PCA2 and PCA3. Hereinafter, FIGS. 12 to 24 are described together. Hereinafter, a connection electrode may be an electrode configured to connect (e.g., electrically connect) conductive lines or conductive patterns arranged on different layers from each other and transmit a signal.

A first conductive layer may be arranged on the substrate 100. As illustrated in FIG. 12, the first conductive layer may include a first electrode layer 210, a driving voltage line PL, and a repair line RL.

The substrate 100 may include a glass material, a ceramic material, a metal material, a flexible, and/or bendable material. The substrate 100 may have a single-layered structure including an organic layer or a multi-layered structure including an organic layer and an inorganic layer. For example, the substrate 100 may have a stacked structure of a first base layer/a barrier layer/a second base layer. Each of the first base layer and the second base layer may be an organic layer including polymer resins. The first base layer and the second base layer may include transparent polymer resins. The barrier layer may be configured to prevent the penetration of external impurities and may include a single layer or multiple layers including an inorganic material, such as SiNₓ or SiOₓ. According to another embodiment, a barrier layer may further be arranged between the substrate 100 and the first conductive layer.

The first electrode layer 210 may be provided as an island (e.g., isolated) type. The first electrode layer 210 may be arranged to be adjacent to the driving voltage line PL in the first circuit area PCA1 and the second circuit area PCA2 and may not be arranged in the third circuit area PCA3.

The driving voltage line PL may extend in the x direction and may be arranged to cross the first circuit area PCA1, the second circuit area PCA2, and the third circuit area PCA3. The driving voltage line PL may include a main line PLa extending in the x direction in each circuit area and a protrusion portion PLb protruding from the main line PLa in a - y direction. An area of the driving voltage line PL and an area of the main line PLa may be different for each circuit area. According to an embodiment, an area of the main line PLa of the driving voltage line PL in the third circuit area PCA3 may be greater than an area of the main line PLa of the driving voltage line PL in the first circuit area PCA1 and the second circuit area PCA2. An area of the main line PLa of the driving voltage line PL in the second circuit area PCA2 may be greater than an area of the main line PLa of the driving voltage line PL in the first circuit area PCA1.

The repair line RL may extend in the x direction and may be arranged to cross the first circuit area PCA1, the second circuit area PCA2, and the third circuit area PCA3.

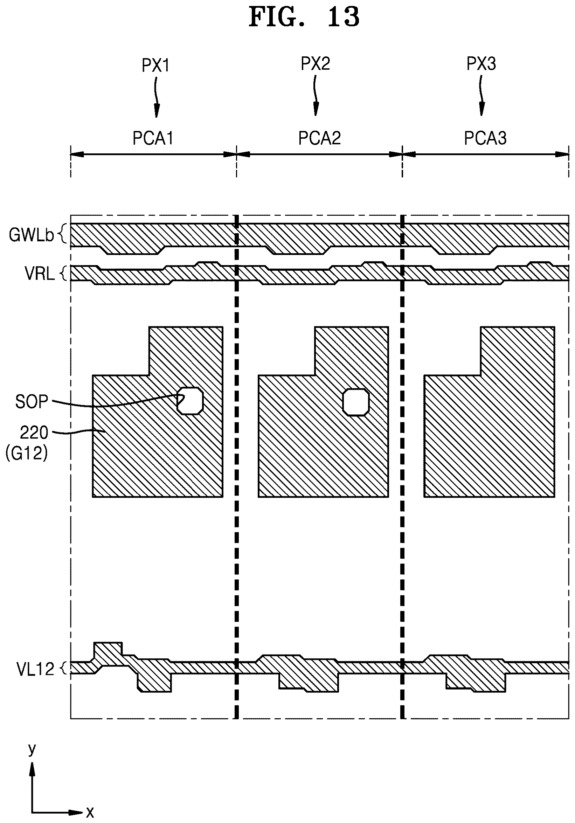

A first insulating layer 111 may be arranged on the substrate 100 to cover the first conductive layer, and a second conductive layer may be arranged on the first insulating layer 111. As illustrated in FIG. 13, the second conductive layer may include a second electrode layer 220, a lower first gate line GWLb, the reference voltage line VRL, the 1-2^{nd} initialization voltage line VL12.

The second electrode layer 220 may be provided as an island type. The second electrode layer 220 may overlap the first electrode layer 210 and the main line PLa of the driving voltage line PL. The second electrode layer 220 may include a second gate electrode G12 of the first transistor T1. An opening SOP overlapping the first electrode layer 210 may be defined in the second electrode layer 220 in the first circuit area PCA1 and the second circuit area PCA2.

The lower first gate line GWLb, the reference voltage line VRL, and the 1-2^{nd} initialization voltage line VL12 may extend in the x direction and may be arranged to cross the first to third circuit areas PCA1 to PCA3.

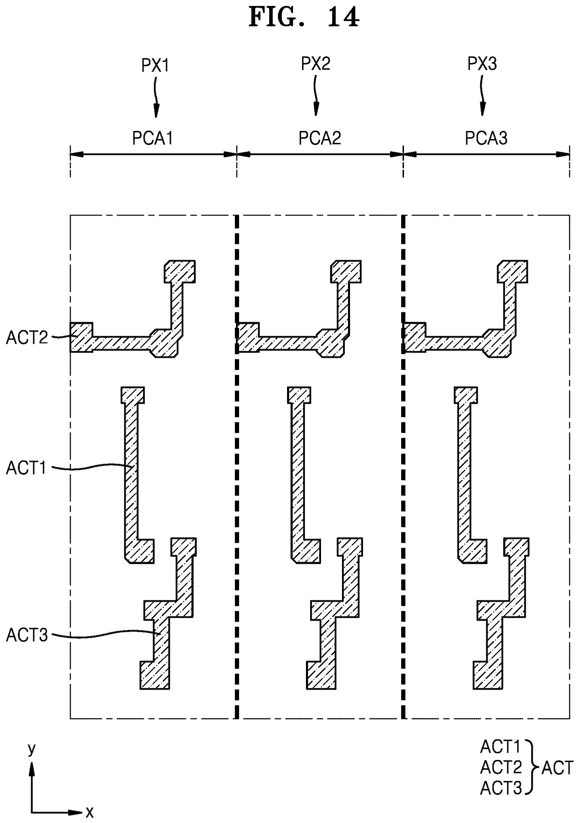

A second insulating layer 112 may be arranged on the first insulating layer 111 to cover the second conductive layer, and a semiconductor layer ACT including an oxide semiconductor may be arranged on the second insulating layer 112 as illustrated in FIG. 14. The semiconductor layer ACT may include a first semiconductor layer ACT1, a second semiconductor layer ACT2, and a third semiconductor layer OACT3. The semiconductor layer ACT may include a channel area, a source area and a drain area at both sides of the channel area of each of the first to sixth transistors T1 to T6. The source area or the drain area may also be interpreted as a source electrode or a drain electrode of the transistor, according to cases.

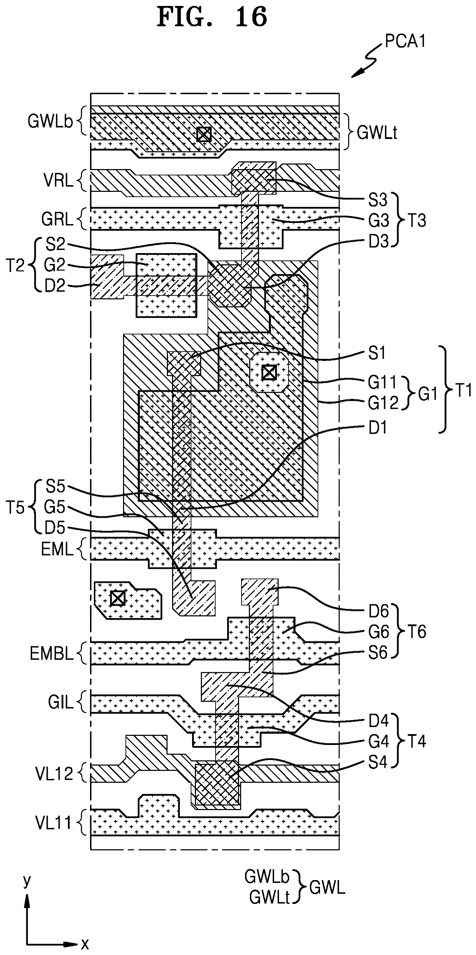

FIG. 16 illustrates the transistors of the first circuit area PCA1. Referring to FIG. 16, the first semiconductor layer ACT1 may include a source area S1 and a drain area D1 of the first transistor T1 and a source area S5 and a drain area D5 of the fifth transistor T5. The second semiconductor layer ACT2 may include a source area S2 and a drain area D2 of the second transistor T2 and a source area S3 and a drain area D3 of the third transistor T3. The third semiconductor layer ACT3 may include a source area S4 and a drain area D4 of the fourth transistor T4 and a source area S6 and a drain area D6 of the sixth transistor T6.

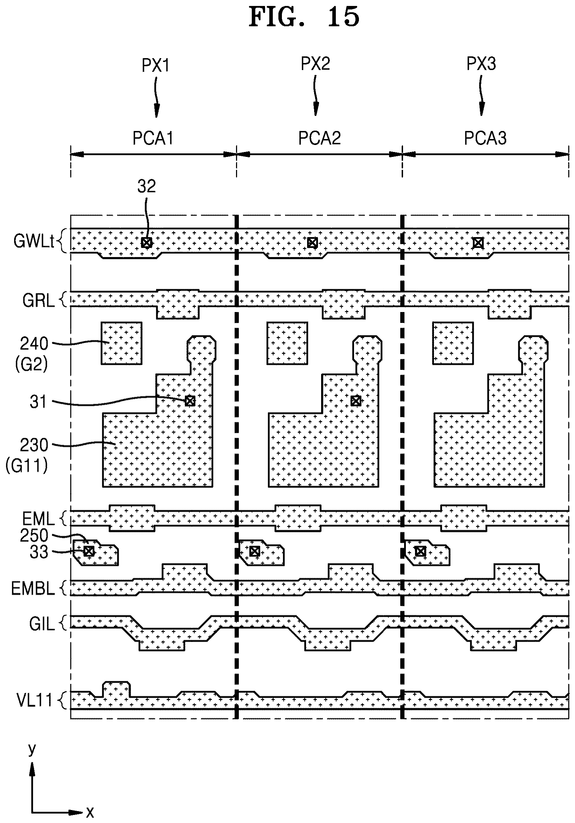

A third insulating layer 113 may be arranged on the second insulating layer 112 to cover the semiconductor layer ACT, and a third conductive layer may be arranged on the third insulating layer 113. As illustrated in FIG. 15, the third conductive layer may include a third electrode layer 230, a fourth electrode layer 240, a connection electrode 250, an upper first gate line GWLt, the second gate line GIL, the third gate line GRL, the fourth gate line EML, the fifth gate line EMBL, and the 1-1^{st} initialization voltage line VL11.

The third electrode layer 230, the fourth electrode layer 240, and the connection electrode 250 may be provided as an island type. The third electrode layer 230, the fourth electrode layer 240, and the connection electrode 250 may be arranged in each of the first to third circuit areas PCA1 to PCA3.

In the first and second circuit areas PCA1 and PCA2, the third electrode layer 230 may be connected (e.g., electrically connected) to the first electrode layer 210 through a contact hole 31 passing through the first to third insulating layers 111 to 113. The contact hole 31 may be insulated from the opening SOP of the second electrode layer 220 and may be arranged in the opening SOP.

In the first to third circuit areas PCA1 to PCA3, the connection electrode 250 may be connected (e.g., electrically connected) to the protrusion portion PLb of the driving voltage line PL through a contact hole 33 passing through the first to third insulating layers 111 to 113.

The upper first gate line GWLt, the second gate line GIL, the third gate line GRL, the fourth gate line EML, the fifth gate line EMBL, and the 1-1^{st} initialization voltage line VL11 may extend in the x direction and may be arranged to cross the first to third circuit areas PCA1 to PCA3.

The upper first gate line GWLt may be connected (e.g., electrically connected) to the lower first gate line GWLb through a contact hole 32 passing through the second and third insulating layers 112 and 113.

As illustrated in FIG. 16, the third conductive layer may include gate electrodes G1 to G6 of the first to sixth transistors T1 to T6. The gate electrodes G1 to G6 may overlap the channel areas of the semiconductor layer ACT.

Referring to FIG. 16, the third electrode layer 230 may include a first gate electrode G11 of the first transistor T1. The first gate electrode G11 may overlap the first semiconductor layer ACT1. The fourth electrode layer 240 may correspond to a gate electrode G2 of the second transistor T2. The fourth electrode layer 240 may overlap the second semiconductor layer ACT2. A gate electrode G3 of the third transistor T3 may be a portion of the third gate line GRL overlapping the second semiconductor layer ACT2. A gate electrode G4 of the fourth transistor T4 may be a portion of the second gate line GIL overlapping the third semiconductor layer ACT3. A gate electrode G5 of the fifth transistor T5 may be a portion of the fourth gate line EML overlapping the first semiconductor layer ACT1. A gate electrode G6 of the sixth transistor T6 may be a portion of the fifth gate line EMBL overlapping the third semiconductor layer ACT3.

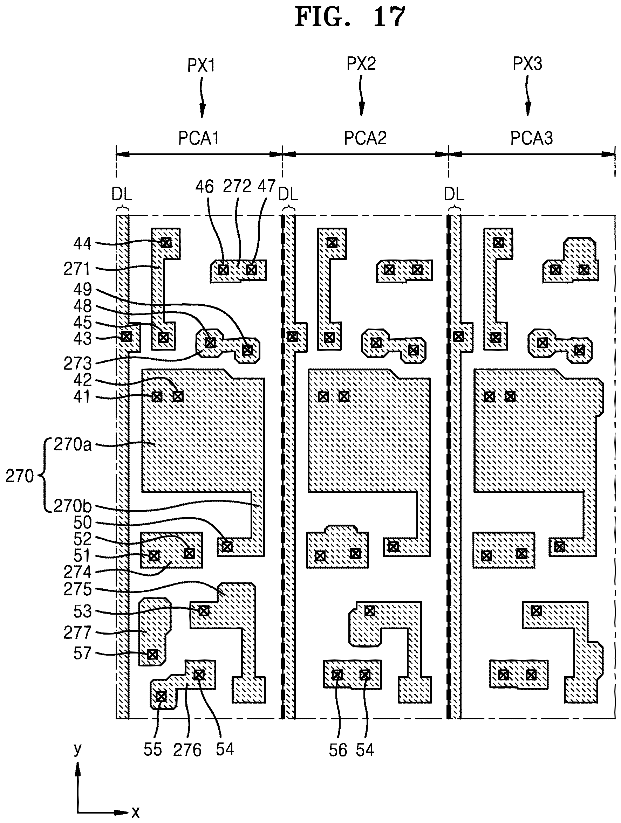

A fourth insulating layer 114 may be arranged on the third insulating layer 113 to cover the third conductive layer, and a fourth conductive layer may be arranged on the fourth insulating layer 114. As illustrated in FIG. 17, the fourth conductive layer may include the data line DL and connection electrodes 270, 271, 272, 273, 274, 275, 276, and 277.

The data line DL may be arranged to extend in the y direction for each circuit area. The data line DL may be connected (e.g., electrically connected) to the drain area D2 of the second transistor T2 through a contact hole 43 passing through the third insulating layer 113 and the fourth insulating layer 114.

The connection electrode 270 may include a first area 270a overlapping the first to third electrode layers 210 to 230 and a second area 270b protruding from the first area 270a in the -y direction. The connection electrode 270 may connect (e.g., electrically connect) the source area S1 of the first transistor T1 to the second gate electrode of the first transistor T1 and the sixth transistor T6.

The first area 270a of the connection electrode 270 may be connected (e.g., electrically connected) to the source area S1 of the first transistor T1 through a contact hole 42 passing through the third and fourth insulating layers 113 and 114. The first area 270a of the connection electrode 270 may be connected (e.g., electrically connected) to the second electrode layer 220 through a contact hole 41 passing through the second to fourth insulating layers 112 to 114. Accordingly, the connection electrode 270 may correspond to a source electrode connected (e.g., electrically connected) to the source area S1 of the first transistor T1. The second electrode layer 220 may correspond to the second gate electrode G12 of the first transistor T1, the second gate electrode G12 facing the first gate electrode G11 of the first transistor T1 and overlapping the channel area of the first transistor T1. With the connection electrode 270 connected to the second electrode layer 220, the second gate electrode G12 of the first transistor T1 may be connected (e.g., electrically connected) to the source area S1 of the first transistor T1.

The second area 270b of the connection electrode 270 may be connected (e.g., electrically connected) to the drain area D6 of the sixth transistor T6 through a contact hole 50 passing through the third and fourth insulating layers 113 and 114.

The connection electrode 271 may be connected (e.g., electrically connected) to the gate electrode G2 of the second transistor T2 through a contact hole 45 passing through the fourth insulating layer 114. The connection electrode 271 may be connected (e.g., electrically connected) to the upper first gate line GWLt through a contact hole 44 passing through the fourth insulating layer 114.

The connection electrode 272 may be connected (e.g., electrically connected) to the source area S3 of the third transistor T3 through a contact hole 46 passing through the third and fourth insulating layers 113 and 114 and may be connected (e.g., electrically connected) to the reference voltage line VRL through a contact hole 47 passing through the second to fourth insulating layers 112 to 114.

The connection electrode 273 may be connected (e.g., electrically connected) to the source area S2 of the second transistor T2 and the drain area D3 of the third transistor T3 through a contact hole 48 passing through the third and fourth insulating layers 113 and 114. The connection electrode 273 may be connected (e.g., electrically connected) to the third electrode layer 230 through a contact hole 49 passing through the fourth insulating layer 114 and may be connected (e.g., electrically connected) to the first gate electrode G11 of the first transistor T1. The connection electrode 273 may correspond to a node electrode corresponding to the first node N1 of FIG. 3. The connection electrode 273 may correspond to a bridge electrode connecting (e.g., electrically connecting) at least two transistors. For example, the connection electrode 273 may correspond to the bridge electrode connecting the first gate electrode G11 of the first transistor T1, the source area S2 of the second transistor T2, and the drain area D3 of the third transistor T3.

The connection electrode 274 may be connected (e.g., electrically connected) to the protrusion portion PLb of the driving voltage line PL through a contact hole 51 passing through the first to fourth insulating layers 111 to 114. The connection electrode 274 may be connected (e.g., electrically connected) to the drain area D5 of the fifth transistor T5 through a contact hole 52 passing through the third and fourth insulating layers 113 and 114. Thus, the drain area D5 of the fifth transistor T5 may be connected (e.g., electrically connected) to the driving voltage line PL.

The connection electrode 275 may be connected (e.g., electrically connected) to the source area S6 of the sixth transistor T6 and the drain area D4 of the fourth transistor T4 through a contact hole 53 passing through the third and fourth insulating layers 113 and 114. The connection electrode 275 may overlap a portion of the repair line RL. The connection electrode 275 may be insulated from the repair line RL, and in the case that defects occur later to the pixel circuit arranged in the circuit area corresponding to the connection electrode 275, the connection electrode 275 may be connected (e.g., electrically connected) to the repair line RL.

In the first circuit area PCA1, the connection electrode 276 may be connected (e.g., electrically connected) to the source area S4 of the fourth transistor T4 through a contact hole 54 passing through the third and fourth insulating layers 113 and 114. The connection electrode 276 may be connected to the 1-1^{st} initialization voltage line VL11 through a contact hole 55 passing through the fourth insulating layer 114.

In the second and third circuit area PCA2 and PCA3, the connection electrode 276 may be connected (e.g., electrically connected) to the source area S4 of the fourth transistor T4 through the contact hole 54 passing through the third and fourth insulating layers 113 and 114. The connection electrode 276 may be connected (e.g., electrically connected) to the 1-2^{nd} initialization voltage line VL12 through a contact hole 56 passing through the second to fourth insulating layers 112 to 114.

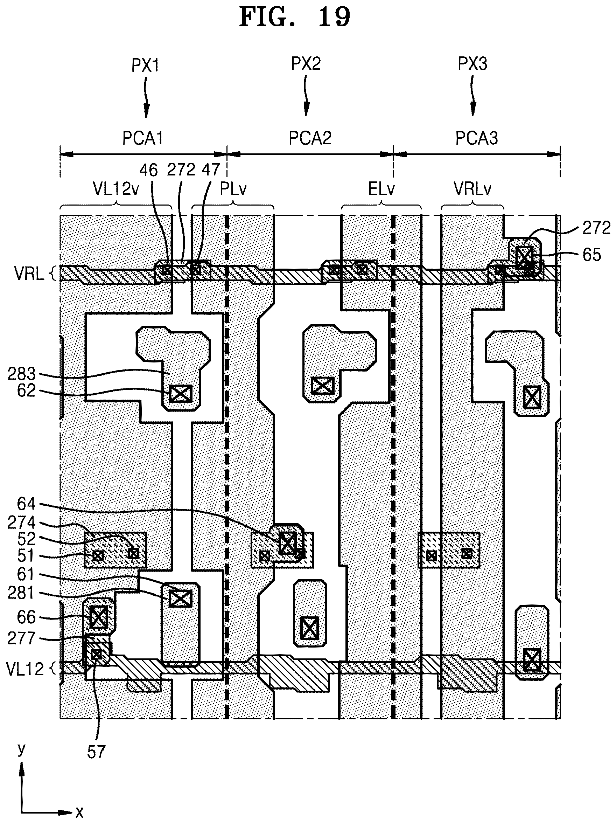

In the first circuit area PCA1, the connection electrode 277 may be connected (e.g., electrically connected) to the 1-2^{nd} initialization voltage line VL12 through a contact hole 58 passing through the second to fourth insulating layers 112 to 114. The connection electrode 277 may be arranged in some first circuit areas PCA1 of the first circuit areas PCA1. For example, the connection electrode 277 may be arranged in only the first circuit areas PCA1 in which a second vertical initialization voltage line VL12v (see FIG. 19) from among vertical conductive lines described below is arranged.

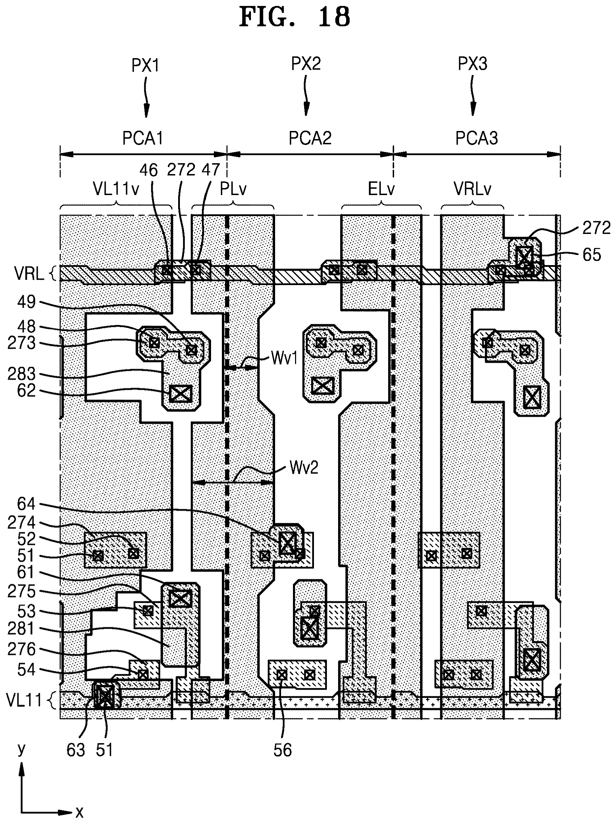

A fifth insulating layer 115 may be arranged above the fourth insulating layer 114 to cover the fourth conductive layer, and a fifth conductive layer may be arranged above the fifth insulating layer 115. As illustrated in FIGS. 18 to 20, the fifth conductive layer may include the vertical conductive lines and connection electrodes 281 and 283. FIGS. 18 to 20 illustrate only some of lower conductive lines connected to the fifth conductive layer, for convenience of illustration and explanation.

The connection electrode 281 may be connected (e.g., electrically connected) to the connection electrode 275 through a contact hole 61 passing through the fifth insulating layer 115 and may be connected (e.g., electrically connected) to the source area S6 of the sixth transistor T6.

The connection electrode 283 may be connected (e.g., electrically connected) to the connection electrode 270 through a contact hole 62 passing through the fifth insulating layer 115. The connection electrode 283 may be arranged to cover and overlap the connection electrode 273, which is a node electrode.

The vertical conductive lines may include a first vertical driving voltage line PLv, a first vertical initialization voltage line VL11v, the second vertical initialization voltage line VL12v, a second vertical driving voltage line ELv, and a vertical reference voltage line VRLv. The vertical conductive lines each may extend in the y direction and may be arranged to be spaced apart from each other in the x direction in the first to third circuit areas PCA1 to PCA3.

Four vertical conductive lines may be arranged to be spaced apart from each other in the x direction in the first to third circuit areas PCA1 to PCA3. For example, four vertical conductive lines from among the first vertical initialization voltage line VL11v, the second vertical initialization voltage line VL12v, the first vertical driving voltage line PLv, the second vertical driving voltage line ELv, and the vertical reference voltage line VRLv may be arranged to be spaced apart from each other in the x direction. The vertical conductive lines may be connected (e.g., electrically connected) to horizontal conductive lines extending in the x direction. The horizontal conductive lines may include the driving voltage line PL, the 1-1^{st} initialization voltage line VL11, the 1-2^{nd} initialization voltage line VL12, and the reference voltage line VRL.

FIG. 18 illustrates an example in which the first vertical initialization voltage line VL11v, the first vertical driving voltage line PLv, the second vertical driving voltage line ELv, and the vertical reference voltage line VRLv are sequentially arranged in the x direction in the first to third circuit areas PCA1 to PCA3.

FIG. 19 illustrates an example in which the second vertical initialization voltage line VL12v, the first vertical driving voltage line PLv, the second vertical driving voltage line ELv, and the vertical reference voltage line VRLv are sequentially arranged in the x direction in the first to third circuit areas PCA1 to PCA3.

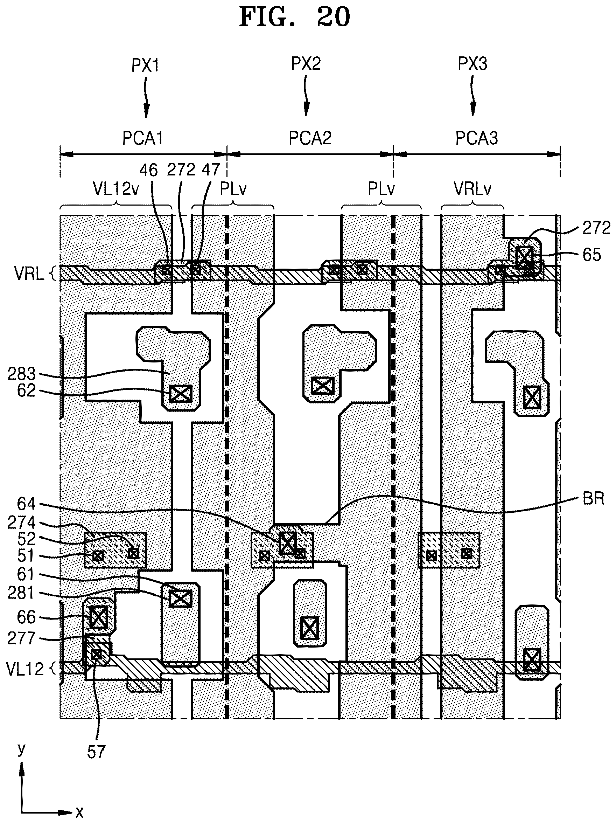

FIG. 20 illustrates an example in which the second vertical initialization voltage line VL12v, the first vertical driving voltage line PLv, the first vertical driving voltage line PLv, and the vertical reference voltage line VRLv are sequentially arranged in the x direction in the first to third circuit areas PCA1 to PCA3. The pair of first vertical driving voltage lines PLv adjacent to each other may be connected by a connection portion BR. The pair of first vertical driving voltage lines PLv may be integrally formed. According to an embodiment, the connection portion BR may be arranged in every second row. For example, as illustrated in FIG. 20, the pair of first vertical driving voltage lines PLv may be connected to each other by the connection portion BR in odd-numbered rows or even-numbered rows and may be spaced apart from each other without the connection portion BR in even-numbered rows or odd-numbered rows.

The first vertical initialization voltage line VL11v may overlap the data line DL arranged in the first circuit area PCA1. The first vertical initialization voltage line VL11v may be connected (e.g., electrically connected) to the connection electrode 276 arranged in the first circuit area PCA1 through a contact hole 63 passing the fifth insulating layer 115. Because the connection electrode 276 may be connected (e.g., electrically connected) to the 1-1^{st} initialization voltage line VL11, the 1-1^{st} initialization voltage line VL11 may have a mesh structure in the display area DA.

The second vertical initialization voltage line VL12v may overlap the data line DL arranged in the first circuit area PCA1. The second vertical initialization voltage line VL12v may be connected (e.g., electrically connected) to the connection electrode 277 arranged in the first circuit area PCA1 through a contact hole 66 passing through the fifth insulating layer 115. Because the connection electrode 277 may be connected (e.g., electrically connected) to the 1-2^{nd} initialization voltage line VL12, the 1-2^{nd} initialization voltage line VL12 may have a mesh structure in the display area DA.

The first vertical driving voltage line PLv may overlap the data line DL arranged in the second circuit area PCA2. The first vertical driving voltage line PLv may be connected (e.g., electrically connected) to the connection electrode 274 arranged in the second circuit area PCA2 through a contact hole 64 passing through the fifth insulating layer 115. Because the connection electrode 274 may be connected (e.g., electrically connected) to the driving voltage line PL, the driving voltage line PL may have a mesh structure in the display area DA.

The second vertical driving voltage line ELv may overlap the data line DL arranged in the third circuit area PCA3. The second vertical driving voltage line ELv may be connected (e.g., electrically connected) to the common voltage supply line 13 (see FIG. 2) arranged in the peripheral area PA.

The vertical reference voltage line VRLv may be arranged in the third circuit area PCA3. The vertical reference voltage line VRLv may be connected (e.g., electrically connected) to the connection electrode 272 arranged in the third circuit area PCA3 through the contact hole 65 passing through the fifth insulating layer 115. Because the connection electrode 272 may be connected (e.g., electrically connected) to the reference voltage line VRL, the reference voltage line VRL may have a mesh structure in the display area DA.

Each of the vertical conductive lines may include, in the x direction, an area having a first width Wv1 and an area having a second width Wv2 which is greater than the first width Wv1, as illustrated in FIG. 18. By increasing the width of the conductive line, the resistance of the conductive line may be reduced, and thus, a voltage drop of a signal transmitted through the conductive line may be reduced.

Although not shown, voltage supply lines connected (e.g., electrically connected) to the horizontal conductive lines and/or the vertical conductive lines may further be arranged in the peripheral area PA. The voltage supply lines may be arranged on at least one of an upper side, a lower side, a left side, and a right side of the display area DA.

The connection electrodes having the same functions and corresponding to the first to third circuit areas PCA1 to PCA3 may have different shapes and locations from each other according to locations of the lines arranged in the first to third circuit areas PCA1 to PCA3.

A sixth insulating layer 116 may be arranged above the fifth insulating layer 115 to cover the fifth conductive layer, and an organic light-emitting diode (OLED: OLED1, OLED2, OLED3) may be arranged above the sixth insulating layer 116 as a display element. The organic light-emitting diode OLED may include a pixel electrode 311, an opposite electrode 315, and an intermediate layer between the pixel electrode 311 and the opposite electrode 315.

The pixel electrode 311 may be connected (e.g., electrically connected) to the connection electrode 281, which is a lower conductive pattern, through a contact hole 71 of the sixth insulating layer 116 and may be connected (e.g., electrically connected) to the first transistor T1. As illustrated in FIG. 21, the pixel electrode 311 connected to the pixel circuit of the first pixel PX1 may be connected (e.g., electrically connected) to the connection electrode 281 arranged in the first circuit area PCA1, and thus, may be connected (e.g., electrically connected) to the first transistor T1. The pixel electrode 311 connected to the pixel circuit of the second pixel PX2 may be connected (e.g., electrically connected) to the connection electrode 281 arranged in the second circuit area PCA2, and thus, may be connected (e.g., electrically connected) to the first transistor T1. The pixel electrode 311 connected to the pixel circuit of the third pixel PX3 may be connected (e.g., electrically connected) to the connection electrode 281 arranged in the third circuit area PCA3, and thus, may be connected (e.g., electrically connected) to the first transistor T1.

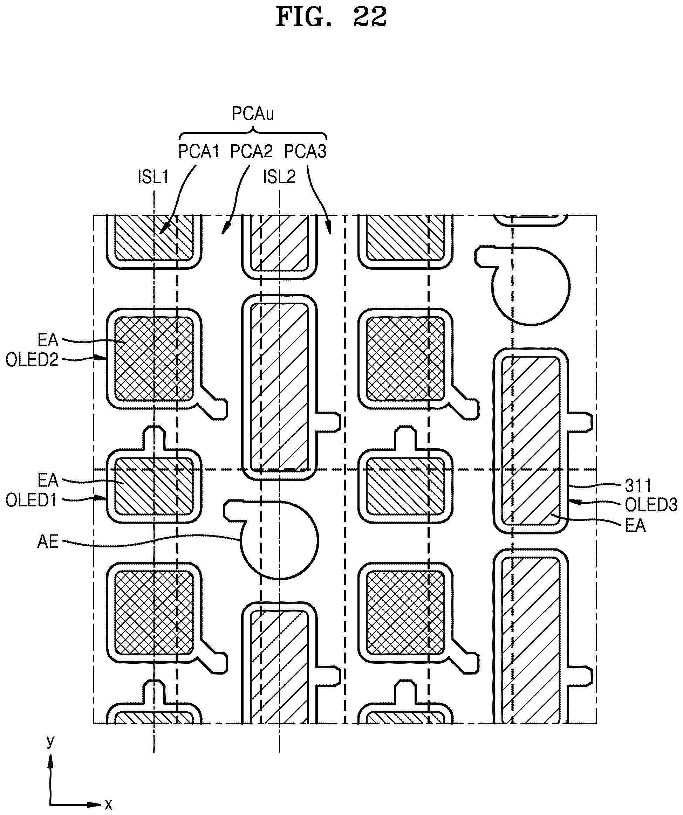

As illustrated in FIG. 22, an auxiliary electrode layer AE may further be arranged on the same layer as the pixel electrode 311. The auxiliary electrode layer AE may be arranged between the pixel electrodes 311 of the third pixel PX3. The auxiliary electrode layer AE may be in contact with the opposite electrode 315 in the display area DA. According to an embodiment, the auxiliary electrode layer AE may be connected (e.g., electrically connected) to the second vertical driving voltage line ELv in the display area DA.

As illustrated in FIG. 23, a seventh insulating layer 117, which is a pixel-defining layer covering an edge of the pixel electrode 311, may be arranged above the pixel electrode 311. An opening 117OP exposing a portion of the pixel electrode 311 and defining an emission area may be defined in the seventh insulating layer 117. The seventh insulating layer 117 may be a single organic insulating layer or multiple organic insulating layers and/or a single inorganic insulating layer or multiple inorganic insulating layers.

The intermediate layer may include an emission layer 313 and a first functional layer below the emission layer 313 and/or a second functional layer above the emission layer 313. The first functional layer may be a hole transport layer HTL. Alternatively, the first functional layer may include a hole injection layer HIL and a hole transport layer HTL. The second functional layer may include an electron transport layer ETL and/or an electron injection layer EIL. The first functional layer and the second functional layer may be integrally formed to correspond to the organic light-emitting diodes OLEDs included in the display area DA. The first functional layer or the second functional layer may be omitted. FIG. 21 illustrates an emission layer 313a of an organic light-emitting diode OLED1 connected (e.g., electrically connected) to the pixel circuit arranged in the first circuit area PCA1, an emission layer 313b of an organic light-emitting diode OLED2 connected (e.g., electrically connected) to the pixel circuit arranged in the second circuit area PCA2, and an emission layer 313c of an organic light-emitting diode OLED3 connected (e.g., electrically connected) to the pixel circuit arranged in the third circuit area PCA3.

FIG. 22 illustrates the pixel electrode 311 and an emission area EA of each of the first to third pixels PX1 to PX3. The emission area EA may be an area in which the emission layer 313 of the organic light-emitting diode OLED is arranged. The emission area EA may be defined by the opening 117OP of the seventh insulating layer 117. Because the emission layer 313 is arranged on the pixel electrode 311, the arrangement of the emission area EA illustrated in FIG. 22 may indicate the arrangement of the pixel electrode 311 or the arrangement of the pixel PX.

The emission area EA may have a polygonal shape, such as a quadrangular shape or an octagonal shape, a circular shape, an oval shape, etc., wherein the polygonal shape may include shapes having round corners (vertexes).

The emission area EA of the first pixel PX1 and the emission area EA of the second pixel PX2 may be arranged to be adjacent to each other in the y direction, and the emission area EA of the third pixel PX3 may be arranged to be adjacent to the emission area EA of the first pixel PX1 and the emission area EA of the second pixel PX2 in the x direction. Accordingly, the emission area EA of the first pixel PX2 and the emission area EA of the second pixel PX2 may be alternately arranged in the y direction along a virtual straight line ISL1, and the emission area EA of the third pixel PX3 may be repeatedly arranged in the y direction along a virtual straight line ISL2.

A length in the x direction and a length in the y direction of each of the emission areas EA of the first to third pixels PX1 to PX3 may be the same as or different from each other. For example, the emission area EA of the first pixel PX1 may have a square shape, and the emission area EA of the second pixel PX2 and the emission area EA of the third pixel PX3 may have a rectangular shape having a long side in the y direction. The length in the y direction of the emission area EA of the third pixel PX3 may be equal to or greater than the sum of the length in the y direction of the emission area EA of the first pixel PX1 and the length in the y direction of the emission area EA of the second pixel PX2.

The emission area EA of the first pixel PX1, the emission area EA of the second pixel PX2, and the emission area EA of the third pixel PX3 may have different areas (sizes) from each other. According to an embodiment, the emission area EA of the third pixel PX3 may have a greater area than the emission area EA of the first pixel PX1. The emission area EA of the third pixel PX3 may have a greater area than the emission area EA of the second pixel PX2. The emission area EA of the second pixel PX2 may have a greater area than the emission area EA of the first pixel PX1.

The opposite electrode 315 may be integrally formed to correspond to the organic light-emitting diodes OLEDs arranged in the display area DA.

Referring to FIG. 23, the source area S1 of the first transistor T1 may be connected (e.g., electrically connected) to the second electrode layer 220 and the connection electrode 270. The third electrode layer 230 and the connection electrode 270 may correspond to an intermediate first electrode C11m and an intermediate second electrode C12m of the first capacitor C1, respectively. The driving voltage line PL and the second electrode layer 220 may correspond to a first electrode C21 and a second electrode C22 of the second capacitor C2, respectively.

Referring to FIG. 24, the second electrode layer 220 may be arranged below the connection electrode 273, which is a node electrode, and the connection electrode 283 may be arranged above the connection electrode 273. The connection electrode 283 may nearly entirely cover the connection electrode 273, and the second electrode layer 220 may nearly entirely cover the connection electrode 273. The connection electrode 283 may function as an upper shielding layer of the connection electrode 273, and the second electrode layer 220 may function as a lower shielding layer of the connection electrode 273.

In the case that a parasitic capacitance is formed due to coupling between the connection electrode 273 and the pixel electrode 311 adjacent to the connection electrode 273, a gate-source voltage (Vgs) of the first transistor T1 connected to the connection electrode 273 may be changed. According to an embodiment, by arranging the connection electrode 283 on the layer between the connection electrode 273 and the pixel electrode 311, the coupling between the pixel electrode 311 and the connection electrode 273 adjacent to each other may be prevented. For example, as illustrated in FIG. 24, the coupling between the connection electrode 273 connected to the first node N1 of the pixel circuit of the second pixel PX2 arranged in the second circuit area PCA2 and the pixel electrode 311 of the third pixel PX3 may be prevented by the connection electrode 283.

The second electrode layer 220 and the connection electrode 283 may be connected (e.g., electrically connected) to the source area S1 of the first transistor T1 through the connection electrode 270. The connection electrode 273 may be connected (e.g., electrically connected) to the third electrode layer 230, which is the first gate electrode G11 of the first transistor T1. The first gate electrode G11 may be connected (e.g., electrically connected) to the first electrode layer 210. Thus, according to an embodiment, in addition to the first capacitor C1 illustrated in FIG. 23, the first capacitor C1 between the first electrode layer 210 and the second electrode layer 220, between the second electrode layer 220 and the third electrode layer 230, and between the connection electrode 273 and the connection electrode 283 may further be formed. The first electrode layer 210 and the second electrode layer 220 may respectively correspond to a lower first electrode C11b and a lower second electrode C12b of the first capacitor C1. The connection electrode 273 and the connection electrode 283 may respectively correspond to an upper first electrode C11t and an upper second electrode C12t of the first capacitor C1.

According to an embodiment, by arranging the connection electrode 283 and the second electrode layer 220 above and below the connection electrode 273, respectively, coupling between the connection electrode 273 and the adjacent conductive layer may be prevented, and thus, a parasitic capacitance may be reduced, and a capacitance of the storage capacitor may be increased. Therefore, the compensation function of the first transistor may be improved, and a brightness difference between adjacent pixels may be minimized.

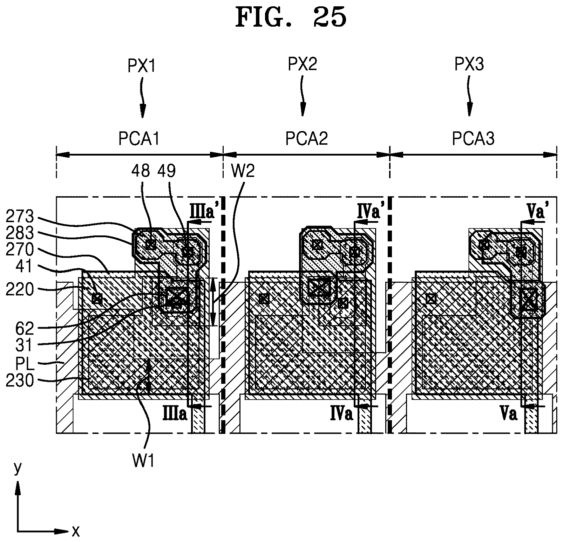

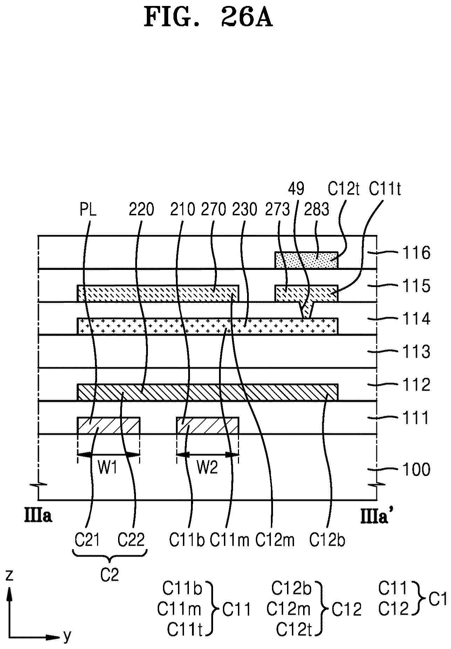

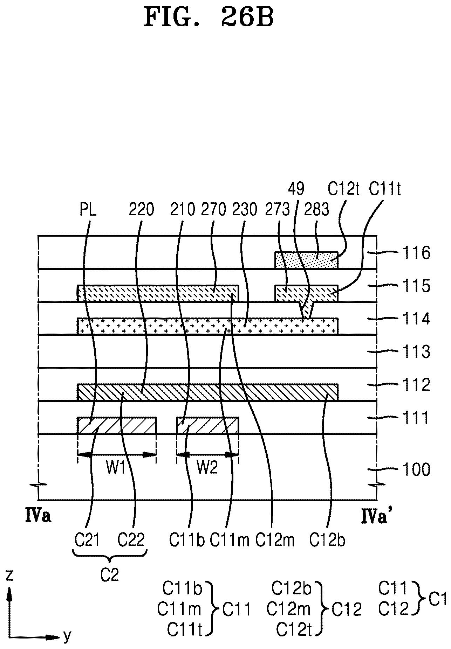

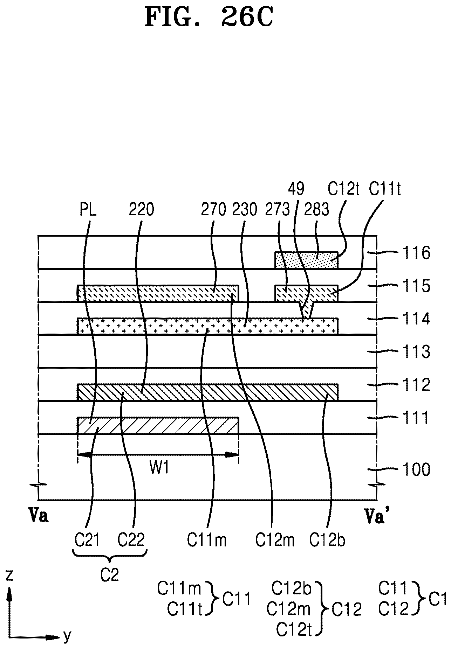

FIG. 25 is a schematic view of a capacitor for each pixel according to an embodiment. FIG. 26a is a schematic cross-sectional view of capacitors of the first pixel, taken along line IIIa-IIIa' of FIG. 25. FIG. 26b is a schematic cross-sectional view of capacitors of the second pixel, taken along a line IVa-IVa' of FIG. 25. FIG. 26c is a schematic cross-sectional view of capacitors of the third pixel, taken along line Va-Va' of FIG. 25.

Referring to FIGS. 26a and 26b, the first electrode layer 210 and the driving voltage line PL may be arranged to be spaced apart from each other in each of the first circuit area PCA1 and the second circuit area PCA2 on the substrate 100. The second electrode layer 220 may be arranged on the first insulating layer 111 and may overlap the first electrode layer 210 and the driving voltage line PL. The third electrode layer 230 may be arranged on the third insulating layer 113 and may overlap the second electrode layer 220. The connection electrode 270 and the connection electrode 273 may be arranged on the fourth insulating layer 114 and may overlap the third electrode layer 230. The connection electrode 283 may be arranged on the fifth insulating layer 115 and may overlap the connection electrode 273.

The first capacitor C1 of the first pixel PX1 and the second pixel PX2 may include the first electrode C11 and the second electrode C12. The first electrode C11 may include the lower first electrode C11b formed by the first electrode layer 210, the intermediate first electrode C11m formed by the third electrode layer 230, and the upper first electrode C11t formed by the connection electrode 273. As illustrated in FIG. 25, the lower first electrode C11b and the intermediate first electrode C11m may be connected (e.g., electrically connected) to each other through the contact hole 31, and the intermediate first electrode C11m and the upper first electrode C11t may be connected (e.g., electrically connected) to each other through the contact hole 49. The second electrode C12 may include the lower second electrode C12b formed by the second electrode layer 220, the intermediate second electrode C12m formed by the connection electrode 270, and the upper second electrode C12t formed by the connection electrode 283. As illustrated in FIG. 25, the lower second electrode C12b and the intermediate second electrode C12m may be connected (e.g., electrically connected) to each other through the contact hole 41, and the intermediate second electrode C12m and the upper second electrode C12t may be connected (e.g., electrically connected) to each other through the contact hole 62.

A capacitance of the first capacitor C1 may be the sum of a capacitance formed by the lower first electrode C11b and the lower second electrode C12b, a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in a z direction are connected in parallel with each other, and thus, may have (obtain) an increased capacitance without an increase of the area in the x direction and the y direction.

The second capacitor C2 of the first pixel PX1 and the second pixel PX2 may include the first electrode C21 formed by the driving voltage line PL and the second electrode C22 formed by the second electrode layer 220.

A minimum width W1 in the y direction of the first electrode C21 of the second capacitor C2 of the first pixel PX1 and a width W2 in the y direction of the lower first electrode C11b of the first capacitor C1 may be the same as each other. A minimum width W1 in the y direction of the first electrode C21 of the second capacitor C2 of the second pixel PX2 along the line IVa-IVa' may be greater than a width W2 in the y direction of the lower first electrode C11b of the first capacitor C1 of the second pixel PX2. The minimum width W1 in the y direction of the first electrode C21 of the second capacitor C2 of the second pixel PX2 may be greater than the minimum width W1 in the y direction of the first electrode C21 of the second capacitor C2 of the first pixel PX1.

The first capacitor C1 and the second capacitor C2 illustrated in FIGS. 26a and 26b may respectively correspond to the first capacitor C1 and the second capacitor C2 illustrated in FIG. 9.

Referring to FIG. 26c, the driving voltage line PL may be arranged in the third circuit area PCA3 on the substrate 100. The second electrode layer 220 may be arranged on the first insulating layer 111 and may overlap the driving voltage line PL. The third electrode layer 230 may be arranged on the third insulating layer 113 and may overlap the second electrode layer 220. The connection electrode 270 and the connection electrode 273 may be arranged on the fourth insulating layer 114 and may overlap the third electrode layer 230. The connection electrode 283 may be arranged on the fifth insulating layer 115 and may overlap the connection electrode 273.

The first capacitor C1 of the third pixel PX3 may include the first electrode C11 and the second electrode C12. The first electrode C11 may include the intermediate first electrode C11m formed by the third electrode layer 230 and the upper first electrode C11t formed by the connection electrode 273. As illustrated in FIG. 25, the intermediate first electrode C11m and the upper first electrode C11t may be connected (e.g., electrically connected) to each other through the contact hole 49. The second electrode C12 may include the lower second electrode C12b formed by the second electrode layer 220, the intermediate second electrode C12m formed by the connection electrode 270, and the upper second electrode C12t formed by the connection electrode 283. As illustrated in FIG. 25, the lower second electrode C12b and the intermediate second electrode C12m may be connected (e.g., electrically connected) to each other through the contact hole 41, and the intermediate second electrode C12m and the upper second electrode C12t may be connected (e.g., electrically connected) to each other through the contact hole 62.

A capacitance of the first capacitor C1 may be the sum of a capacitance formed by the lower second electrode C12b and the intermediate first electrode C11m, a capacitance formed by the intermediate first electrode C11m and the intermediate second electrode C12m, and a capacitance formed by the upper first electrode C11t and the upper second electrode C12t. The first capacitor C1 may have a structure in which sub-capacitors formed by conductive lines overlapping each other in the z direction are connected in parallel with each other, and thus, may have (obtain) an increased capacitance without an increase of the area in the x direction and the y direction.

The second capacitor C2 of the third pixel PX3 may include the first electrode C21 formed by the driving voltage line PL and the second electrode C22 formed by the second electrode layer 220.

A minimum width W1 in the y direction of the first electrode C21 of the second capacitor C2 of the third pixel PX3 may be greater than the minimum width W1 in the y direction of the first electrode C21 of the second capacitor C2 of the first pixel PX1 and the second pixel PX2.

The first capacitor C1 and the second capacitor C2 illustrated in FIG. 26c may correspond to the first capacitor C1 and the second capacitor C2 illustrated in FIG. 10.

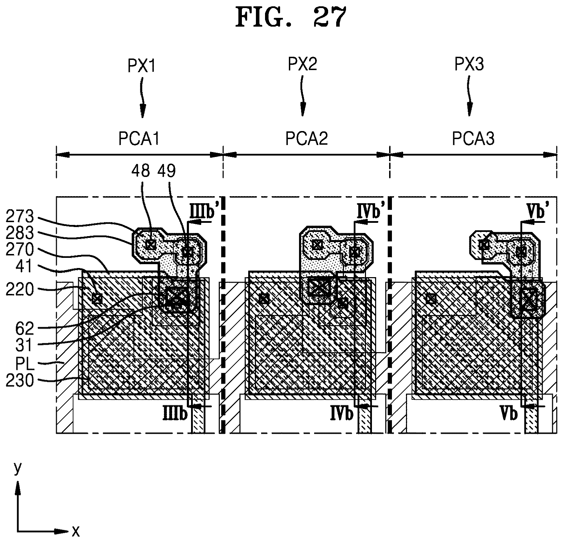

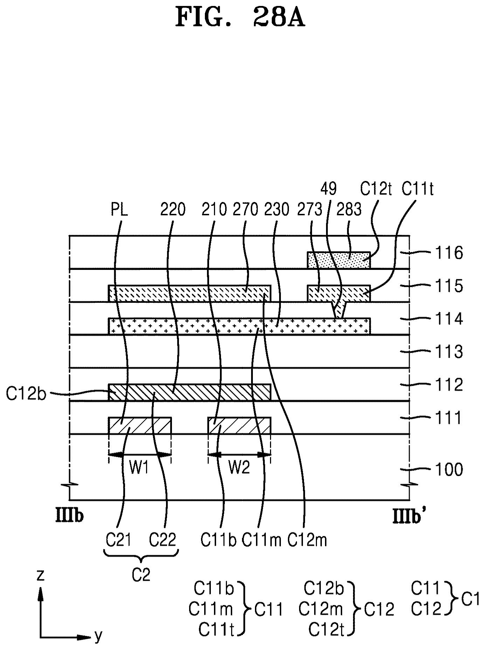

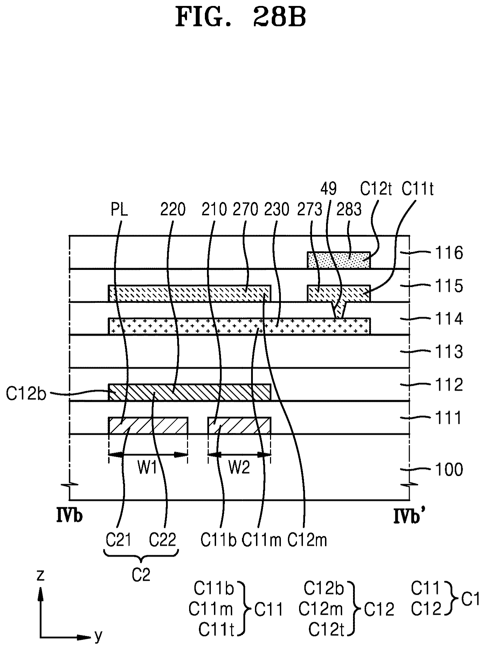

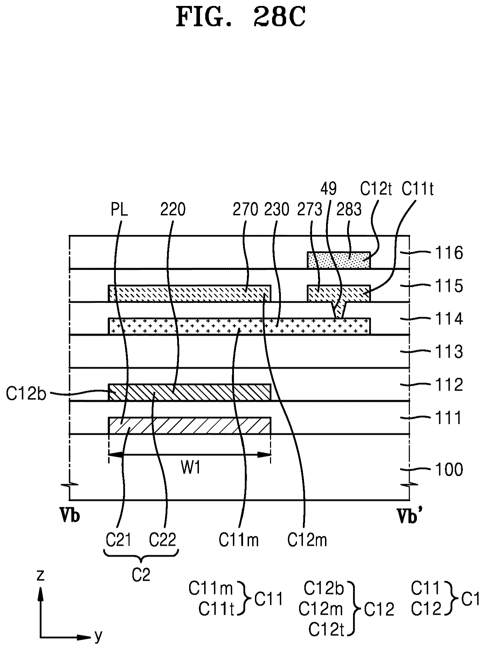

FIG. 27 is a schematic view of a capacitor for each pixel according to an embodiment. FIG. 28a is a schematic cross-sectional view of capacitors of the first pixel, taken along line IIIb-IIIb' of FIG. 27. FIG. 28b is a schematic cross-sectional view of capacitors of the second pixel, taken along line IVb-IVb' of FIG. 27. FIG. 28c is a schematic cross-sectional view of capacitors of the third pixel, taken along line Vb-Vb' of FIG. 27.

Referring to FIG. 27, the connection electrode 283, as a shielding layer, may be arranged only above the connection electrode 273, and the second electrode layer 220 may not overlap the connection electrode 273 below the connection electrode 273.

Referring to FIGS. 28a to 28c, due to a reduced area of the second electrode layer 220, the capacitance of the first capacitor C1 of each of the first to third pixels PX1 to PX3 may be less than the capacitance of the first capacitor C1 of each of the first to third pixels PX1 to PX3 illustrated in FIGS. 26a to 26c.

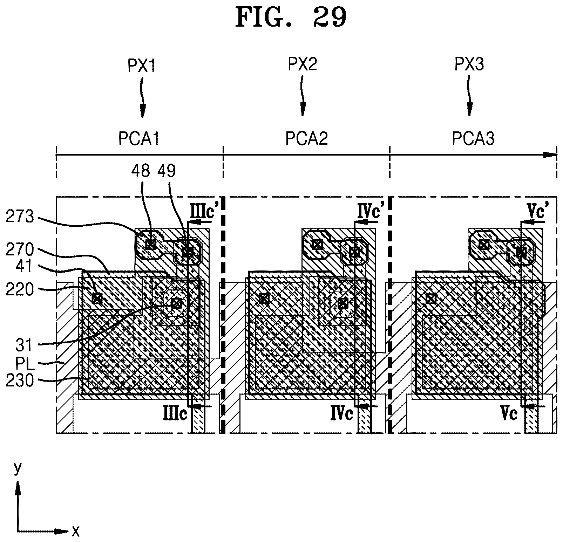

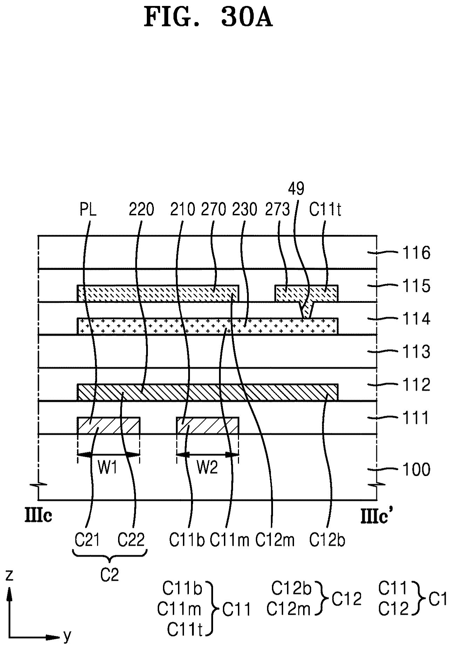

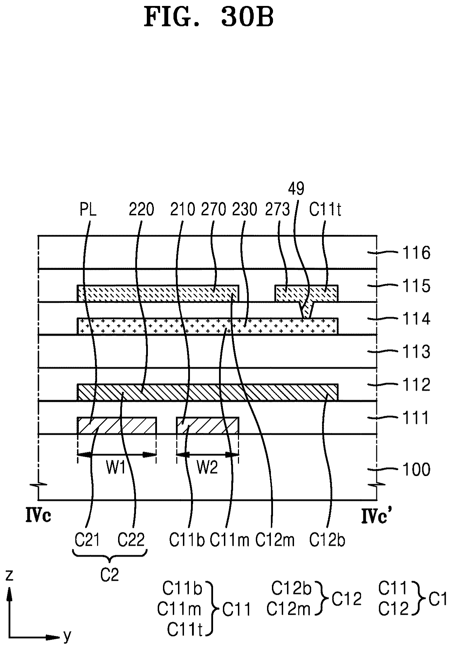

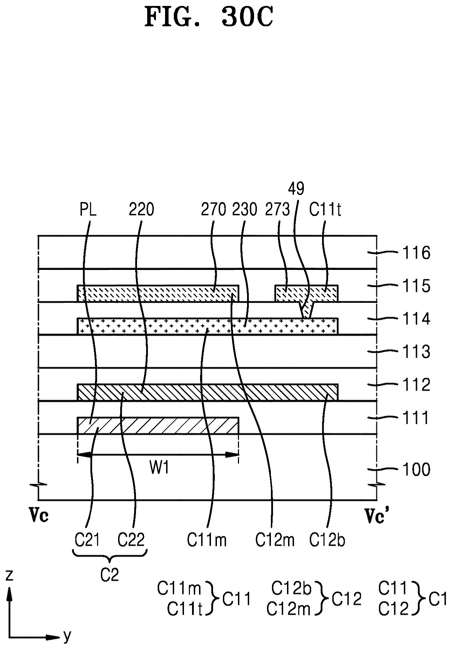

FIG. 29 is a schematic view of a capacitor for each pixel according to an embodiment. FIG. 30a is a schematic cross-sectional view of capacitors of the first pixel, taken along line IIIc-IIIc' of FIG. 29. FIG. 30b is a schematic cross-sectional view of capacitors of the second pixel, taken along line IVc-IVc' of FIG. 29. FIG. 30c is a schematic cross-sectional view of capacitors of the third pixel, taken along line Vc-Vc' of FIG. 29.

Referring to FIG. 29, the connection electrode 283 above the connection electrode 273 may be omitted, and the second electrode layer 220 may, as a shielding layer, overlap the connection electrode 273 below the connection electrode 273.

Referring to FIGS. 28a to 28c, due to the omission of the connection electrode 283, the capacitance of the first capacitor C1 of each of the first to third pixels PX1 to PX3 may be less than the capacitance of the first capacitor C1 of each of the first to third pixels PX1 to PX3 illustrated in FIGS. 26a to 26c.

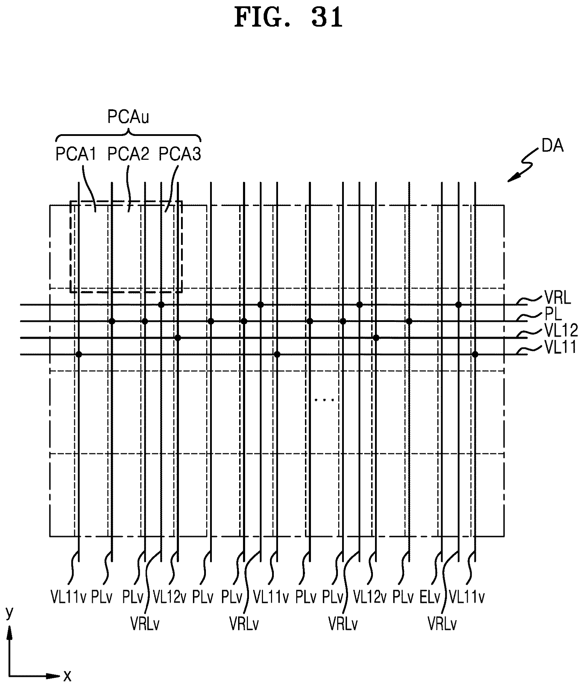

FIGS. 31 to 33 are schematic plan views of vertical conductive lines according to an embodiment.

As illustrated in FIGS. 31 to 33, the arrangement of four vertical conductive lines may be changed for each unit circuit area PCAu.

According to an embodiment, as illustrated in FIG. 31, a first vertical conductive line in the unit circuit area PCAu may be the first vertical initialization voltage line VL11v or the second vertical initialization voltage line VL12v. A fourth vertical conductive line in the unit circuit area PCAu may be the vertical reference voltage line VRLv. Second and third vertical conductive lines in the unit circuit area PCAu may be a pair of first vertical driving voltage lines PLv or a pair of the first vertical driving voltage line PLv and the second vertical driving voltage line ELv.

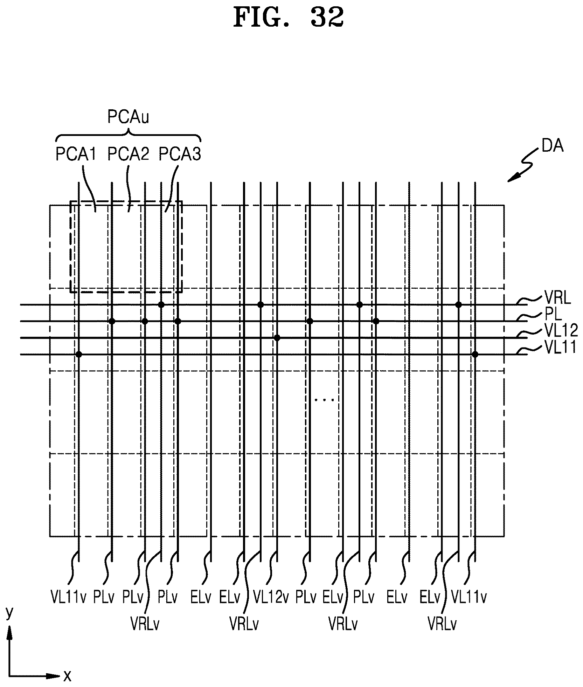

According to an embodiment, as illustrated in FIG. 32, a first vertical conductive line in the unit circuit area PCAu may be the first vertical initialization voltage line VL11v, the second vertical initialization voltage line VL12v, or the first vertical driving voltage line PLv. A fourth vertical conductive line in the unit circuit area PCAu may be the vertical reference voltage line VRLv. Second and third vertical conductive lines in the unit circuit area PCAu may be a pair of first vertical driving voltage lines PLv, a pair of second vertical driving voltage lines ELv, or a pair of the first vertical driving voltage line PLv and the second vertical driving voltage line ELv.

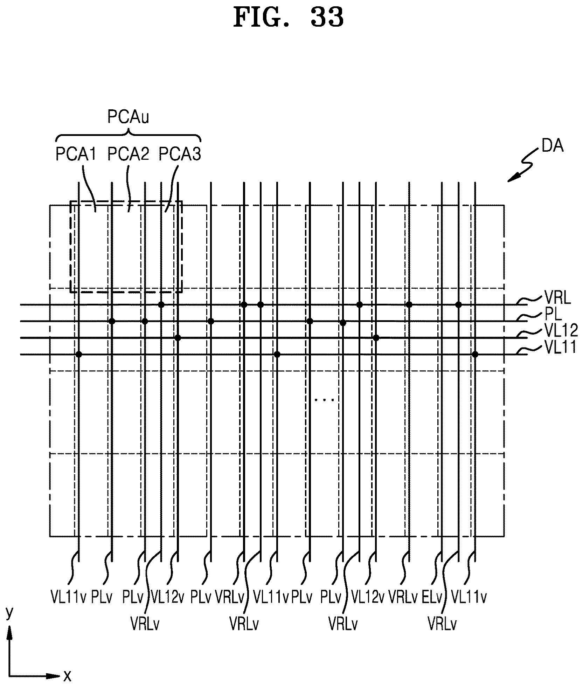

According to an embodiment, as illustrated in FIG. 33, a first vertical conductive line in the unit circuit area PCAu may be the first vertical initialization voltage line VL11v or the second vertical initialization voltage line VL12v. A fourth vertical conductive line in the unit circuit area PCAu may be the vertical reference voltage line VRLv. Second and third vertical conductive lines in the unit circuit area PCAu may be a pair of first vertical driving voltage lines PLv, a pair of the first vertical driving voltage line PLv and the vertical reference voltage line VRLv, or a pair of the second vertical driving voltage line ELv and the vertical reference voltage line VRLv.

According to an embodiment, a conductive line which has to have a reduced resistance, for example, a conductive line, to which a signal which has to have a reduced voltage drop is transmitted, may be additionally arranged. For example, as illustrated in FIGS. 31 to 33, instead of arranging four different vertical conductive lines in the unit circuit area PCAu, one of the first vertical driving voltage line PLv, the second vertical driving voltage line ELv, and the vertical reference voltage line VRLv may be additionally arranged in a second or third position in the unit circuit area PCAu. In the case that the same vertical conductive lines are arranged to be adjacent to each other based on the additional arrangement of the conductive lines, the vertical conductive lines may be connected to each other. For example, a pair of first vertical driving voltage lines PLv adjacent to each other, a pair of second vertical driving voltage lines ELv adjacent to each other, or a pair of vertical reference voltage lines VRLv adjacent to each other may be integrally formed as each other and may be connected to each other by the connection portion BR as illustrated in FIG. 20.

The first vertical initialization voltage line VL11v may be connected (e.g., electrically connected) to the 1-1^{st} initialization voltage line VL11 through the connection electrode 276 arranged in the circuit area in which the first vertical initialization voltage lineVL11v is arranged. The second vertical initialization voltage line VL12v may be connected (e.g., electrically connected) to the 1-2^{nd} initialization voltage line VL12 through the connection electrode 276 arranged in the circuit area in which the second vertical initialization voltage lineVL12v is arranged. The first vertical driving voltage line PLv may be connected (e.g., electrically connected) to the driving voltage line PL through the connection electrode 274 arranged in the circuit area in which the first vertical driving voltage line PLv is arranged. The second vertical driving voltage line ELv may be connected (e.g., electrically connected) to the opposite electrode 315 through the auxiliary electrode layer AE arranged in the display area DA. The vertical reference voltage line VRLv may be connected (e.g., electrically connected) to the reference voltage line VRL through the connection electrode 272 arranged in the circuit area in which the vertical reference voltage line VRLv is arranged.

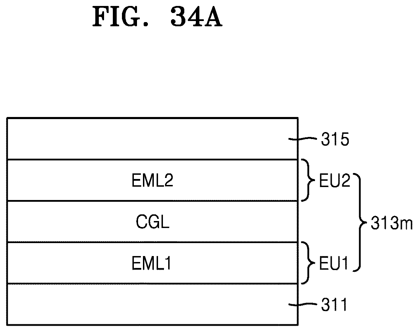

FIGS. 34a to 35b are schematic cross-sectional views showing a structure of a display element according to an embodiment.

An organic light-emitting diode OLED as the display element according to an embodiment may include the pixel electrode 311, the opposite electrode 315, and an intermediate layer 313m between the pixel electrode 311 (a first electrode, an anode) and the opposite electrode 315 (a second electrode, a cathode).

The pixel electrode 311 may include a transmissive conductive oxide, such as indium tin oxide (ITO), indium zinc oxide (IZO), zinc oxide (ZnO), indium oxide (In₂O₃), indium gallium oxide (IGO), and/or aluminium zinc oxide (AZO). The pixel electrode 311 may include a reflective layer including Ag, Mg, Al, Pt, Pd, Au, Ni, Nd, Ir, Cr, or a compound thereof. For example, the pixel electrode 311 may have a triple-layered structure of ITO/Ag/ITO.

The opposite electrode 315 may be arranged on the intermediate layer 313m. The opposite electrode 315 may include a metal having a low work function, an alloy, an electrically conductive compound, or an arbitrary combination thereof. For example, the opposite electrode 315 may include Li, Ag, Mg, Al, Al-Li, Ca, Mg-In, Mg-Ag, Yb, Ag-Yb, ITO, IZO, or an arbitrary combination thereof. The opposite electrode 315 may include a transmissive electrode, a transflective electrode, or a reflection electrode.

The intermediate layer 313m may include a polymer material or a low molecular organic material emitting a certain color of light. The intermediate layer 313m may further include a metal-containing compound, such as an organic metal compound, and an inorganic material, such as quantum dots, in addition to various organic materials.

According to an embodiment, the intermediate layer 313m may include one emission layer and a first functional layer and a second functional layer below and above the emission layer, respectively. The first functional layer may include, for example, a hole transport layer HTL, or a hole transport layer HTL and a hole injection layer HIL. The second functional layer may include an electron transport layer ETL and/or an electron injection layer EIL. The first functional layer or the second functional layer may be omitted. The first functional layer and the second functional layer may be integrally formed to correspond to the organic light-emitting diodes OLEDs included in the display area DA.

According to an embodiment, the intermediate layer 313m may include at least two emitting units and a charge generation layer CGL, wherein the at least two emitting units may be stacked between the pixel electrode 311 and the opposite electrode 315, and the charge generation layer CGL may be arranged between the at least two emitting units. In the case that the intermediate layer 313m includes the emitting unit and the charge generation layer CGL, the organic light-emitting diode OLED may be a tandem light-emitting device. In the case that the organic light-emitting diode OLED has the stacked structure of the emitting units, the organic light-emitting diode OLED may have improved color purity and emission efficiency.

One emitting unit may include an emission layer and a first functional layer and a second functional layer below and above the emission layer, respectively. The charge generation layer CGL may include a negative charge generation layer and a positive charge generation layer. Based on the negative charge generation layer and the positive charge generation layer, the emission efficiency of the organic light-emitting diode OLED, which is the tandem light-emitting device including the emission layers, may be further increased.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

According to an embodiment, as illustrated in FIG. 34a, the organic light-emitting diode OLED may include a first emitting unit EU1 including a first emission layer EML1 and a second emitting unit EU2 including a second emission layer EML2, the first emitting unit EU1 and the second emitting unit EU2 being stacked. The charge generation layer CGL may be provided between the first emitting unit EU1 and the second emitting unit EU2. For example, the organic light-emitting diode OLED may include the pixel electrode 211, the first emission layer EML1, the charge generation layer CGL, the second emission layer EML2, and the opposite electrode 315 that are stacked on each other. The first functional layer and the second functional layer may be included below and above the first emission layer EML1, respectively. The first functional layer and the second functional layer may be included below and above the second emission layer EML2, respectively. The first emission layer EML1 may be a blue emission layer, and the second emission layer EML2 may be a yellow emission layer.

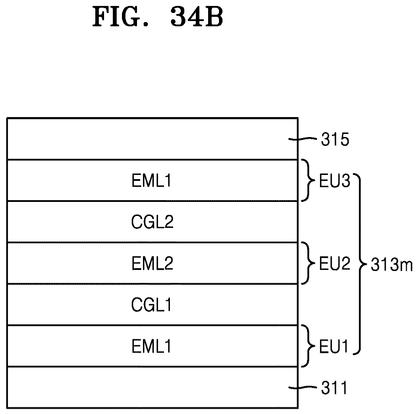

According to an embodiment, as illustrated in FIG. 34b, the organic light-emitting diode OLED may include the first emitting unit EU1 and a third emitting unit EU3 including the first emission layer EML1 and the second emitting unit EU2 including the second emission layer EML2. A first charge generation layer CGL1 may be provided between the first emitting unit EU1 and the second emitting unit EU2, and a second charge generation layer CGL2 may be provided between the second emitting unit EU2 and the third emitting unit EU3. For example, the organic light-emitting diode OLED may include the pixel electrode 311, the first emission layer EML1, the first charge generation layer CGL1, the second emission layer EML2, the second charge generation layer CGL2, the first emission layer EML1, and the opposite electrode 315 that are stacked on each other. The first functional layer and the second functional layer may be included below and above the first emission layer EML1, respectively. The first functional layer and the second functional layer may be included below and above the second emission layer EML2, respectively. The first emission layer EML1 may be a blue emission layer, and the second emission layer EML2 may be a yellow emission layer.

According to an embodiment, the organic light-emitting diode OLED may include the second emitting unit EU2 that may further include a third emission layer EML3 and/or a fourth emission layer EML4 directly contacting the second emission layer EML2 below and/or above the second emission layer EML2, in addition to the second emission layer EML2. Here, to directly contact may denote that no layer may be arranged between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

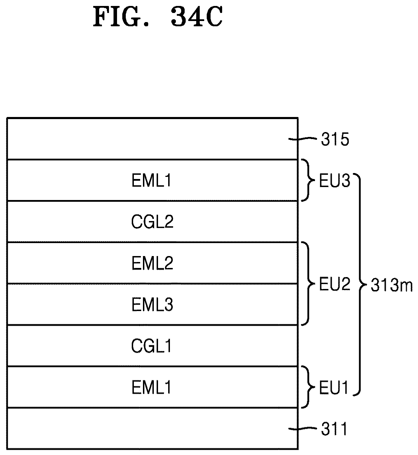

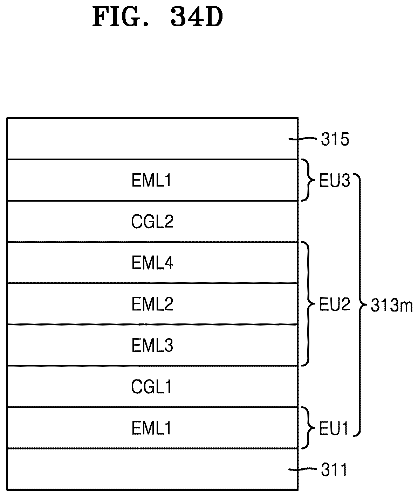

For example, as illustrated in FIG. 34c, the organic light-emitting diode OLED may include the pixel electrode 311, the first emission layer EML1, the first charge generation layer CGL1, the third emission layer EML3, the second emission layer EML2, the second charge generation layer CGL2, the first emission layer EML1, and the opposite electrode 315 that are stacked on each other. Alternatively, as illustrated in FIG. 34d, the organic light-emitting diode OLED may include the pixel electrode 311, the first emission layer EML1, the first charge generation layer CGL1, the third emission layer EML3, the second emission layer EML2, the fourth emission layer EML4, the second charge generation layer CGL2, the first emission layer EML1, and the opposite electrode 315 that are stacked on each other.

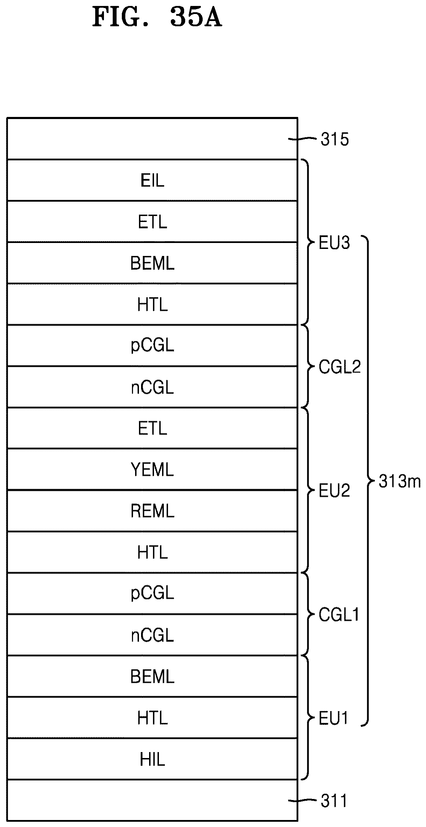

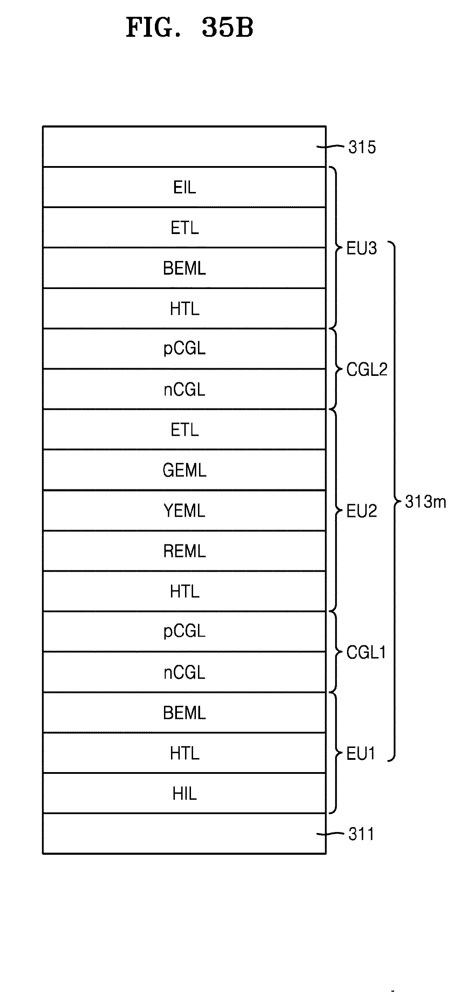

FIG. 35a is a cross-sectional view showing an example of the organic light-emitting diode of FIG. 34c, and FIG. 35b is a cross-sectional view showing an example of the organic light-emitting diode of FIG. 34d.

Referring to FIG. 35a, the organic light-emitting diode OLED may include the first emitting unit EU1, the second emitting unit EU2, and the third emitting unit EU3 that are stacked. The first charge generation layer CGL1 may be provided between the first emitting unit EU1 and the second emitting unit EU2, and the second charge generation layer CGL2 may be provided between the second emitting unit EU2 and the third emitting unit EU3. Each of the first charge generation layer CGL1 and the second charge generation layer CGL2 may include a negative charge generation layer nCGL and a positive charge generation layer pCGL.

The first emitting unit EU1 may include a blue emission layer BEML. The first emitting unit EU1 may further include a hole injection layer HIL and a hole transport layer HTL between the pixel electrode 311 and the blue emission layer BEML. According to an embodiment, a p-doping layer may further be included between the hole injection layer HIL and the hole transport layer HTL. The p-doping layer may be formed by doping the hole injection layer HIL with a p-type doping material. According to an embodiment, at least one of a blue light auxiliary layer, an electron block layer, and a buffer layer may further be included between the blue emission layer BEML and the hole transport layer HTL. The blue light auxiliary layer may increase the emission efficiency of the blue emission layer BEML. The blue light auxiliary layer may increase the emission efficiency of the blue emission layer BEML by adjusting a hole charge balance. The electron block layer may prevent the injection of electrons into the hole transport layer HTL. The buffer layer may compensate for a resonance distance according to a wavelength of the light emitted from the emission layer.

The second emitting unit EU2 may include a yellow emission layer YEML and a red emission layer REML directly contacting the yellow emission layer YEML below the yellow emission layer YEML. The second emitting unit EU2 may further include a hole transport layer HTL between the positive charge generation layer pCGL of the first charge generation layer CGL1 and the red emission layer REML and may further include an electron transport layer ETL between the yellow emission layer YEML and the negative charge generation layer nCGL of the second charge generation layer CGL2.

The third emitting unit EU3 may include the blue emission layer BEML. The third emitting unit EU3 may further include a hole transport layer HTL between the positive charge generation layer pCGL of the second charge generation layer CGL2 and the blue emission layer BEML. The third emitting unit EU3 may further include an electron transport layer ETL and an electron injection layer EIL between the blue emission layer BEML and the opposite electrode 315. The electron transport layer ETL may include a single layer or multiple layers. According to an embodiment, at least one of a blue light auxiliary layer, an electron block layer, and a buffer layer may further be included between the blue emission layer BEML and the hole transport layer HTL. At least one of a hole block layer and a buffer layer may further be included between the blue emission layer BEML and the electron transport layer ETL. The hole block layer may prevent the injection of holes into the electron transport layer ETL.

The organic light-emitting diode OLED illustrated in FIG. 35b may have a different stack structure of the second emitting unit EU2 from the organic light-emitting diode OLED illustrated in FIG. 35a, and except for the stack structure of the second emitting unit EU2, may have the same structure as the organic light-emitting diode OLED illustrated in FIG. 35a. Referring to FIG. 35b, the second emitting unit EU2 may include the yellow emission layer YEML, the red emission layer REML directly contacting the yellow emission layer YEML below the yellow emission layer YEML, and a green emission layer GEML directly contacting the yellow emission layer YEML above the yellow emission layer YEML. The second emitting unit EU2 may further include a hole transport layer HTL between the positive charge generation layer pCGL of the first charge generation layer CGL1 and the red emission layer REML and may further include an electron transport layer ETL between the green emission layer GEML and the negative charge generation layer nCGL of the second charge generation layer CGL2.

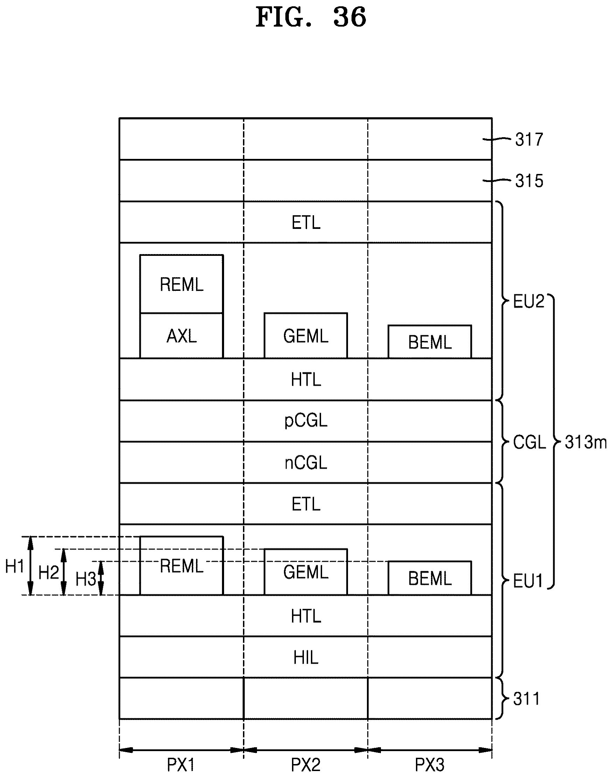

FIG. 36 is a schematic cross-sectional view showing a structure of a pixel of a display apparatus according to an embodiment.

Referring to FIG. 36, the display apparatus may include pixels. The pixels may include a first pixel PX1, a second pixel PX2, and a third pixel PX3. Each of the first to third pixels PX1 to PX3 may include the pixel electrode 311, the opposite electrode 315, and the intermediate layer 313m. According to an embodiment, the first pixel PX1 may include a red pixel, the second pixel PX2 may include a green pixel, and the third pixel PX3 may include a blue pixel. Here, the pixel may include an organic light-emitting diode OLED as a display element, and the organic light-emitting diode OLED of each pixel may be connected (e.g., electrically connected) to a pixel circuit.

The pixel electrode 311 may be separately provided in each of the first pixel PX1, the second pixel PX2, and the third pixel PX3.

The intermediate layer 313m of the organic light-emitting diode OLED of each of the first through third pixels PX1 through PX3 may include a first emitting unit EU1 and a second emitting unit EU2 that are stacked, and a charge generation layer CGL between the first emitting unit EU1 and the second emitting unit EU2. The charge generation layer CGL may include a negative charge generation layer nCGL and a positive charge generation layer pCGL. The charge generation layer CGL may be a common layer continually formed throughout the first through third pixels PX1 through PX3.

The first emitting unit EU1 of the first pixel PX1 may include a hole injection layer HIL, a hole transport layer HTL, a red emission layer REML, and an electron transport layer ETL that are stacked on each other on the pixel electrode 311. The first emitting unit EU1 of the second pixel PX2 may include a hole injection layer HIL, a hole transport layer HTL, a green emission layer GEML, and an electron transport layer ETL that are stacked on each other on the pixel electrode 311. The first emitting unit EU1 of the third pixel PX3 may include a hole injection layer HIL, a hole transport layer HTL, a blue emission layer BEML, and an electron transport layer ETL that are stacked on each other on the pixel electrode 311. Each of the hole injection layer HIL, the hole transport layer HTL, and the electron transport layer ETL of each of the first emitting units EU1 may be a common layer continually formed throughout the first through third pixels PX1 through PX3.

The second emitting unit EU2 of the first pixel PX1 may include a hole transport layer HTL, an auxiliary layer AXL, a red emission layer REML, and an electron transport layer ETL that are stacked on each other on the charge generation layer CGL. The second emitting unit EU2 of the second pixel PX2 may include a hole transport layer HTL, a green emission layer GEML, and an electron transport layer ETL that are stacked on each other on the charge generation layer CGL. The second emitting unit EU2 of the third pixel PX3 may include a hole transport layer HTL, a blue emission layer BEML, and an electron transport layer ETL that are stacked on each other on the charge generation layer CGL. Each of the hole transport layer HTL and the electron transport layer ETL of each of the second emitting units EU1 may be a common layer continually formed throughout the first through third pixels PX1 through PX3. According to an embodiment, in the second emitting units EU2 of the first through third pixels PX1 through PX3, at least one of a hole block layer and a buffer layer may further be included between the emission layer and the electron transport layer ETL.

A thickness H1 of the red emission layer REML, a thickness H2 of the green emission layer GEML, and a thickness H3 of the blue emission layer BEML may be determined according to a resonance distance. The auxiliary layer AXL may be an area added to adjust the resonance distance and may include a resonance auxiliary material. For example, the auxiliary layer AXL may include the same material as the hole transport layer HTL.

FIG. 36 illustrates that the auxiliary layer AXL may be included in only the first sub-pixel PX1. However, an embodiment is not limited thereto. For example, the auxiliary layer AXL may be provided in at least one of the first through third pixels PX1 through PX3 to adjust the resonance distance of the at least one of the first through third pixels PX1 through PX3.

The display apparatus may further include a capping layer 317 arranged outside the opposite electrode 315. The capping layer 317 may increase emission efficiency based on a constructive interference principle. Therefore, because the light extraction efficiency of the organic light-emitting diode OLED is increased, the emission efficiency of the organic light-emitting diode OLED may be increased.

While embodiments have been described with reference to the figures, it will be understood by those of ordinary skill in the art that various changes in form and details may be made therein without departing from the spirit and scope of the disclosure. Therefore, the true technical protection scope of the present invention should be determined by the technical idea of the attached patent claims.

## Claims

1. A display apparatus, comprising:
a first transistor including:
a first gate electrode; and
a first semiconductor layer;
a second transistor including:
a second gate electrode; and
a second semiconductor layer;
a node electrode connecting the first transistor to the second transistor;
a first conductive layer disposed above the node electrode and overlapping the node electrode in plan view; and
a pixel electrode disposed above the first conductive layer and disposed around the node electrode.

2. The display apparatus of claim 1, wherein the node electrode connects the first gate electrode of the first transistor to an end of the second semiconductor layer of the second transistor.

3. The display apparatus of claim 2, wherein the first conductive layer is connected to an end of the first semiconductor layer of the first transistor.

4. The display apparatus of claim 3, wherein the node electrode is disposed on a layer between the first gate electrode of the first transistor and the first conductive layer.

5. The display apparatus of claim 3, further comprising:
a second conductive layer connected to an end of the first semiconductor layer of the first transistor, wherein
the node electrode is disposed on a layer between the first conductive layer and the second conductive layer, and
the first conductive layer overlaps the second conductive layer in plan view.

6. The display apparatus of claim 5, further comprising:
a first electrode disposed on a substrate, wherein
the first electrode is disposed on a layer between the substrate and the second conductive layer,
the second conductive layer overlaps the first electrode in plan view, and
the first gate electrode of the first transistor overlaps the second conductive layer in plan view.

7. The display apparatus of claim 6, wherein the second conductive layer overlaps a channel area of the first semiconductor layer of the first transistor in plan view.

8. The display apparatus of claim 6, further comprising:
a first conductive line connected to the first electrode and extending in a first direction; and
a second conductive line connected to another end of the second semiconductor layer of the second transistor and extending in a second direction.

9. The display apparatus of claim 8, further comprising:
a first vertical conductive line connected to the first conductive line and extending in the second direction that is perpendicular to the first direction; and
a second vertical conductive line connected to the second conductive line and extending in the second direction.

10. The display apparatus of claim 9, wherein the first vertical conductive line, the second vertical conductive line, and the second conductive layer are disposed on a same layer.

11. The display apparatus of claim 6, further comprising:
a second electrode, wherein
the second electrode and the first electrode are disposed on a same layer, and
the second electrode is connected to the node electrode.

12. A display apparatus, comprising:
in each of a first circuit area in which a first pixel circuit is disposed and a second circuit area in which a second pixel circuit is disposed,
a node electrode connecting a driving transistor to a switching transistor; and
a first conductive layer disposed above the node electrode and overlapping the node electrode in plan view,
wherein a pixel electrode connected to a driving transistor of the second circuit area is disposed around the node electrode disposed in the first circuit area.

13. The display apparatus of claim 12, wherein the node electrode connects a gate electrode of the driving transistor to an end of a semiconductor layer of the switching transistor.

14. The display apparatus of claim 13, wherein the first conductive layer is connected to an end of a semiconductor layer of the driving transistor.

15. The display apparatus of claim 14, wherein the node electrode is disposed on a layer between the gate electrode of the driving transistor and the first conductive layer.

16. The display apparatus of claim 14, further comprising:
in each of the first circuit area and the second circuit area, a second conductive layer connected to the end of the semiconductor layer of the driving transistor, wherein
the node electrode is disposed on a layer between the first conductive layer and the second conductive layer,
the first conductive layer overlaps the second conductive layer in plan view, and
the gate electrode of the driving transistor overlaps the second conductive layer in plan view.

17. The display apparatus of claim 16, further comprising:
a first electrode and a second electrode disposed to be spaced apart from each other in the first circuit area, wherein
the first electrode and the second electrode are disposed on a layer between a substrate and the second conductive layer disposed in the first circuit area,
the second conductive layer disposed in the first circuit area overlaps the first electrode and the second electrode in plan view,
the first electrode is connected to a driving voltage line through which a driving voltage is supplied, and
the second electrode is connected to the node electrode disposed in the first circuit area.

18. The display apparatus of claim 17, further comprising:
a third electrode disposed in the second circuit area, wherein
the third electrode and the first electrode are disposed on a same layer,
the second conductive layer disposed in the second circuit area overlaps the third electrode in plan view, and
the third electrode is connected to the driving voltage line.

19. The display apparatus of claim 18, wherein an overlapping area of the first electrode and the second conductive layer in the first circuit area is different from an overlapping area of the third electrode and the second conductive layer in the second circuit area.

20. The display apparatus of claim 18, further comprising:
a vertical conductive line connected to the driving voltage line and extending in a direction that is perpendicular to an extension direction of the driving voltage line.
